# NEW EUROPEAN PATENT SPECIFICATION

(11) **EP 2 012 258 B2**
(45) Date of publication and mention of the opposition decision: **22.10.2014**
(45) Mention of the grant of the patent: 28.09.2011
(21) Application number: 07737818.0
(22) Date of filing: 06.03.2007
(51) Int. Cl.: G06K 19/077, G06K 19/07, H05K 1/16, B42D 25/00, G09F 3/00

(54) **ARTICLE PROVIDED WITH ELECTROMAGNETICALLY COUPLED MODULE**
ARTIKEL MIT ELEKTROMAGNETISCH GEKOPPELTEN MODULEN
ARTICLE AYANT UN MODULE COUPLE DE MANIERE ELECTROMAGNETIQUE

(30) Priority: 26.04.2006 JP 2006122487; 30.06.2006 JP 2006182686; 25.12.2006 JP 2006347460
(43) Date of publication of application: 07.01.2009
(60) Divisional application: 11182911.5
(73) Proprietor: Murata Manufacturing Co. Ltd., Nagaokakyo-shi, Kyoto 617-8555 (JP)
(72) Inventor: KATO, Noboru, Nagaokakyo-shi, Kyoto 617-8555 (JP); KIMURA, Ikuhei, Nagaokakyo-shi, Kyoto 617-8555 (JP); IWASAKI, Kimikazu, Nagaokakyo-shi, Kyoto 617-8555 (JP); ISHINO, Satoshi, Nagaokakyo-shi, Kyoto 617-8555 (JP)
(74) Representative: Zimmermann, Tankred Klaus
(86) International application number: PCT/JP2007/054243
(87) International publication number: WO 2007/125683

(56) References cited:
- EP-A1- 1 347 533
- EP-A2- 0 977 145
- WO-A1-2006/028707
- DE-A1- 10 258 670
- JP-A- 2001 168 628
- JP-A- 2001 351 083
- JP-A- 2001 351 084
- JP-A- 2002 109 492
- JP-A- 2005 352 858
- JP-A- 2006 039 902
- JP-A- 2006 067 479
- JP-A- 2006 072 706
- JP-A- 2006 102 953
- US-A1- 20060 000 915
- US-B1- 6 172 608

## Description

### Technical Field

The present invention relates to an article with an electromagnetic-coupling module and more particularly, to an article with an electromagnetic-coupling module including a wireless IC chip used in an RFID (Radio Frequency Identification) system.

### Background Art

In recent years, as article management systems, RFID systems, in which communication is performed by a non-contact method between a reader/writer that generates an induced electromagnetic field and an IC tag (hereinafter referred to as a "wireless IC device") storing predetermined information attached to an article in order to exchange information, have been developed. As wireless IC devices used for the RFID systems, for example, wireless IC devices disclosed in Patent Documents 1 and 2 have been known.

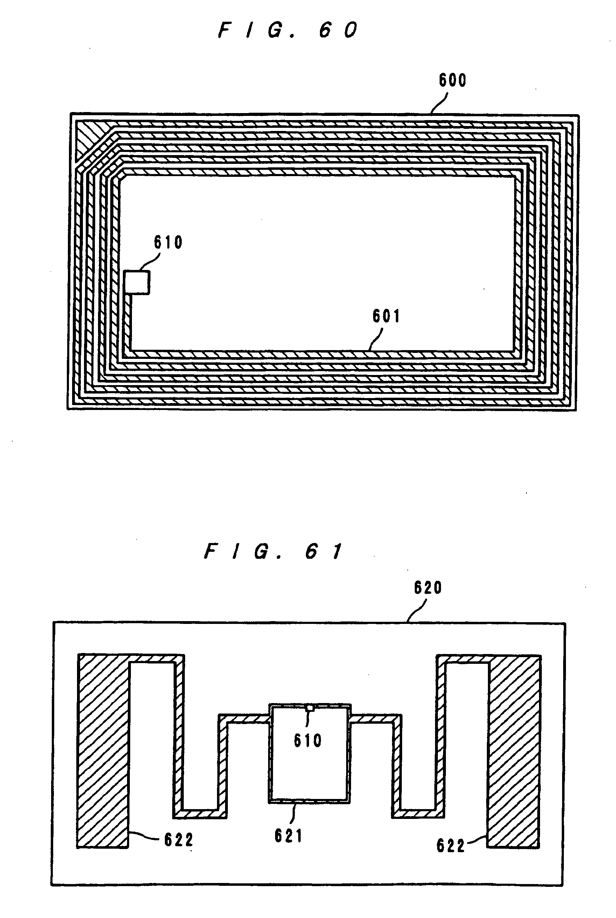

As shown in Fig. 60, a wireless IC device, in which an antenna pattern 601 is provided on a plastic film 600, and a wireless IC chip 610 is attached to one end of the antenna pattern 601, is provided. As shown in Fig. 61, a wireless IC device, in which an antenna pattern 621 and radiation electrodes 622 are provided on a plastic film 620, and the wireless IC chip 610 is attached at a predetermined place of the antenna pattern 621, is provided.

However, in the conventional wireless IC devices, the wireless IC chip 610 is directly connected to and mounted on the antenna pattern 601 or 621 by using an Au bump for electrical connection. Therefore, it is necessary to position a very small wireless IC chip 610 on the film 600 or 620 having a large area. However, mounting the very small wireless IC chip 610 on the large film 600 or 620 is extremely difficult and has a problem that position deviation occurring at the time of mounting will change resonance frequency characteristics of the antenna. Furthermore, resonance frequency characteristics of the antenna also change if the antenna pattern 601 or 621 is rounded or sandwiched between dielectrics (for example, inserted in a book).

Applications of wireless IC devices are limitless. At present, however, since the resonance frequency characteristics of an antenna change depending on how the antenna is disposed, it is difficult to attach wireless IC devices to various articles.
Patent Document 1: Japanese Unexamined Patent Application Publication No. 2005-136528
Patent Document 2: Japanese Unexamined Patent Application Publication No. 2005-244778

EP 1 347 533 A1 describes an antenna for RFID which can be mounted directly on the surface of a management object without using a spacer whatever material the surface of the object might be made of. The antenna for RFID is electrically connected with an IC chip or capacitor and mounted on an article. The antenna for RFID comprises a conductive member formed into a flat plate and mounted on the article at its back and a coil body fixed directly or with a predetermined spacing on a conductive member, spirally wound and having such a number of turns or a diameter that it has a predetermined characteristics value in the wound state

### Summary of the Invention

It is an object of the present invention to provide an article with an electromagnetic-coupling module including a wireless IC chip and having stable frequency characteristics.

This object is achieved by an article according to claim 1.

In order to achieve the above-described object, an article with an electromagnetic-coupling module according to the present invention comprises an article and an electromagnetic-coupling module. The electromagnetic-coupling module includes a wireless IC chip, and a feeder circuit board on which the wireless IC chip is mounted and in which a feeder circuit including a resonance circuit having a predetermined resonance frequency is provided. The article includes a radiation plate for radiating a transmission signal supplied from the feeder circuit of the electromagnetic-coupling module via electromagnetic coupling and/or for supplying a received reception signal to the feeder circuit via electromagnetic coupling.

In the article with an electromagnetic-coupling module according to the present invention, the wireless IC chip is mounted on the feeder circuit board and is integrated with the radiation plate via the feeder circuit board. Since the feeder circuit board has a very small area compared with the radiation plate, the wireless IC chip can be mounted on the feeder circuit board at extremely high accuracy.

The frequency of a transmission signal radiated from the radiation plate and the frequency of a received signal to be supplied to the wireless IC chip are substantially determined by the resonance frequency of the resonance circuit in the feeder circuit board. "The frequencies are substantially determined" means that the frequencies may shift slightly due to a position relationship between the feeder circuit board and the radiation plate. That is, since the frequencies of the transmission/received signals are determined in the feeder circuit board on which the wireless IC chip is mounted at high accuracy, the frequency characteristics do not change regardless of the shape, the size, the position and the like of the radiation plate. For example, even if the radiation plate is rolled or sandwiched between dielectrics, the frequency characteristics do not change, and stable frequency characteristics can be obtained. Therefore, it is possible to incorporate various types of articles in an RFID system.

In the article with an electromagnetic-coupling module according to the present invention, the radiation plate may be a metal member that is originally part of the article itself. For example, if the article is an automobile, a metal body thereof can be used as a radiation plate, or if the article is a mobile terminal device, a metal housing thereof can be used as a radiation plate. Furthermore, the radiation plate may be a metal pattern attached to the article as a radiation plate. For example, if the article is clothes wrapped in wrapping paper, a pattern of a metal film may be attached to the wrapping paper, and the metal film pattern may be used as a radiation plate.

The wireless IC chip not only stores information of an article to which the electromagnetic-coupling module is attached but also can rewrite the information, and may have an information processing function other than that of an RFID system.

In the article with an electromagnetic-coupling module according to the present invention, the resonance circuit is preferably a lumped-constant resonance circuit formed of a capacitor element and an inductor element. The lumped-constant resonance circuit may be an LC parallel resonance circuit or an LC series resonance circuit, or may be configured to include a plurality of LC series resonance circuits or a plurality of LC parallel resonance circuits. The resonance circuit can also be configured as a distributed-constant resonance circuit. In that case, the inductor of the resonance circuit is configured by a strip line. However, if the resonance circuit is configured as a lumped-constant resonance circuit formed of a capacitor element and an inductor element, size reduction can be easily achieved, and the resonance circuit is less affected by other elements such as the radiation plate. If the resonance circuit includes a plurality of resonance circuits, the resonance circuits are coupled with one another, and the band of the transmission signal is widened.

Furthermore, when the capacitor element is disposed downstream of the wireless IC chip and between the wireless IC chip and the inductor element, surge resistant is improved. Since a surge is a low-frequency electric current up to 200 MHz, the surge can be cut by a capacitor, and surge destruction of the wireless IC chip can be prevented.

The feeder circuit board may be a multilayer board in which a plurality of dielectric layers or magnetic layers are stacked. In this case, the capacitor element and the inductor element are formed on the surface of and/or inside the multilayer board. By configuring the resonance circuit by a multilayer board, elements (an electrode pattern, etc.) constituting the resonance circuit can be formed not only on the surface of the board but also inside the board, thereby making it possible to downsize the board. The layout flexibility of the resonance circuit elements is increased, and higher performance of the resonance circuit can also be achieved. The multilayer board may be a resin multilayer board obtained by stacking a plurality of resin layers or may be a ceramic multilayer board obtained by stacking a plurality of ceramic layers. Furthermore, the multilayer board may be a thin-film multilayer board using a thin-film forming technology. When the multi layer board is a ceramic multilayer board, it is preferable that the ceramic layer be formed using a low-temperature sintered ceramic material. This is because silver or copper having a low resistance can be used as a resonance circuit member.

On the other hand, the feeder circuit board may be a single-layer board of a dielectric or a magnetic material. In this case, the capacitor element and/or the inductor element are formed on the surface of a single-layer board. The material of the single-layer board may be resin or ceramic. The capacitance of the capacitor element may be formed between planar-shaped electrodes formed on the obverse and reverse surfaces of the single-layer board, or can be formed between electrodes arranged side by side on one surface of the single-layer board.

The feeder circuit board is preferably a rigid resin or ceramic board. If the board is rigid, even when the wireless IC device is bonded to an object of any shape, the frequency of the transmission signal is stabilized. Furthermore, the wireless IC chip can be stably mounted on the rigid board.

The electric length of the radiation plate is preferably an integral multiple of a half wavelength of the resonance frequency, and the gain becomes maximum. However, since the frequency is substantially determined by the resonance circuit, the electric length of the radiation plate does not necessarily need to be an integral multiple of a half wavelength of the resonance frequency. This is a major advantage as compared with a case in which the radiation plate is an antenna element having a specific resonance frequency.

Furthermore, for the connection between the wireless IC chip and the feeder circuit board, various forms can be adopted. For example, a chip-side electrode pattern may be provided in the wireless IC chip, and a first board-side electrode pattern may be provided on the feeder circuit board, and the chip-side electrode pattern is directly connected electrically to the first board-side electrode pattern. In this case, they can be connected using solder, a conductive resin, an Au bump, or the like.

The chip-side electrode pattern and the first board-side electrode pattern may be connected by means of capacitive coupling or magnetic coupling. If the connection is made by capacitive coupling or magnetic coupling, solder or conductive resin does not need to be used, and the wireless IC chip can be bonded to the board using an adhesive agent such as resin. In this case, the chip-side electrode pattern and the first board-side electrode pattern do not need to be formed on the surface of the wireless IC chip or on the surface of the feeder circuit board. For example, a resin film may be formed on the surface of the chip-side electrode pattern, or the first board-side electrode pattern may be formed in an internal layer of the multilayer board.

In the case of using capacitive coupling, the area of the first board-side electrode pattern is preferably larger than the area of the chip-side electrode pattern. Even if the position accuracy at the time of mounting the wireless IC chip on the feeder circuit board varies slightly, variations in the capacitance formed between the two electrode patterns are reduced. Moreover, although it is difficult to form a large electrode pattern on a small wireless IC chip, it is not difficult to form a large electrode pattern on the feeder circuit board since the board is comparatively large.

In the case of using magnetic coupling, as compared with capacitive coupling, the mounting accuracy of a wireless IC chip on the feeder circuit board is not so high, and therefore, the mounting is further facilitated. Each of the chip-side electrode pattern and the first board-side electrode pattern is preferably a coil-shaped electrode pattern. The design of a coil-shaped electrode pattern such as a spiral shape or a helical shape is easy. If the frequency is high, a meandering pattern is effective.

On the other hand, for the connection between the feeder circuit board and the radiation plate, various forms can be adopted. For example, a second board-side electrode pattern and a radiation plate may be connected by capacitive coupling or by magnetic coupling. I f the connection is made by capacitive coupling or by magnetic coupling, it is not necessary to use solder or conductive resin, the feeder circuit board may be bonded to the radiation plate using an adhesive agent such as resin. In this case, the second board-side electrode pattern does not need to be formed on the surface of the feeder circuit board. For example, the second board-side electrode pattern may be formed in an internal layer of the multilayer board.

In the case of using magnetic coupling, the second board-side electrode pattern is preferably a coil-shaped electrode pattern. Since it is easy to control magnetic flux with a coil-shaped electrode pattern of a spiral or helical shape, the design is easy. If the frequency is high, a meandering pattern can be used. In the case of using magnetic coupling, it is preferable not to prevent a change in magnetic flux caused in the second board-side electrode pattern (coil-shaped electrode pattern). For example, it is preferable that an opening be formed in the radiation plate. As a result, the transfer efficiency of signal energy is improved and also, a shift of frequency due to the bonding between the feeder circuit board and the radiation plate can be reduced.

### Advantages

According to the present invention, a wireless IC chip can be mounted on a feeder circuit board at extremely high accuracy. Furthermore, since the frequencies of a transmission signal and a received signal are determined by the feeder circuit provided in the feeder circuit board, even if an electromagnetic-coupling module is combined with a radiation plate of various forms, frequency characteristics do not change, and stable frequency characteristics can be obtained. Therefore, by using a metal that is originally possessed by an article or a metal pattern attached to an article as a radiation plate, it is possible to incorporate various articles in an RFID system, and it is possible to perform asset management of the articles.

### Brief Description of the Drawings

Fig. 1 is a perspective view showing a first example of an electromagnetic-coupling module.
Fig. 2 is a sectional view of the first example.
Fig. 3 is an equivalent circuit diagram of the first example.
Fig. 4 is an exploded perspective view showing a feeder circuit board of the first example.
Figs. 5 (A) and 5 (B) are perspective views showing a connection state between a wireless IC chip and the feeder circuit board.
Fig. 6 is a perspective view showing a second example of the electromagnetic-coupling module.
Fig. 7 is a perspective view showing a third example of the electromagnetic-coupling module.
Fig. 8 is a sectional view showing a fourth example of the electromagnetic-coupling module.
Fig. 9 is an equivalent circuit diagram showing a fifth example of the electromagnetic-coupling module.
Fig. 10 is an equivalent circuit diagram showing a sixth example of the electromagnetic-coupling module.
Fig. 11 is an equivalent circuit diagram showing a seventh example of the electromagnetic-coupling module.
Fig. 12 is a sectional view showing an eighth example of the electromagnetic-coupling module.
Fig. 13 is an equivalent circuit diagram of the eighth example.
Fig. 14 is an exploded perspective view showing a feeder circuit board of the eighth example.
Fig. 15 is an equivalent circuit diagram showing a ninth example of the electromagnetic-coupling module.
Fig. 16 is an equivalent circuit diagram showing a tenth example of the electromagnetic-coupling module.
Fig. 17 is an exploded perspective view showing a feeder circuit board of the tenth example. Fig. 18 is a perspective view showing an eleventh example of the electromagnetic-coupling module.
Fig. 19 is a sectional view showing a twelfth example of the electromagnetic-coupling module.
Fig. 20 is an exploded perspective view showing a feeder circuit board of the twelfth example.
Fig. 21 is an equivalent circuit diagram showing a thirteenth example.
Fig. 22 is an exploded perspective view showing a feeder circuit board of the thirteenth example.
Fig. 23 is an equivalent circuit diagram showing a fourteenth example of the electromagnetic-coupling module.
Fig. 24 is an exploded perspective view showing a feeder circuit board of the fourteenth example.
Fig. 25 is a graph showing reflection characteristics of the fourteenth example.
Fig. 26 is an equivalent circuit diagram showing a fifteenth example of the electromagnetic-coupling module.
Fig. 27 is an exploded perspective view showing a feeder circuit board of the fifteenth example.
Figs. 28 (A) and 28 (B) show a wireless IC chip of the fifteenth example, wherein Fig. 28 (A) is a bottom view and Fig. 28 (B) is an enlarged sectional view.
Fig. 29 is an equivalent circuit diagram showing a sixteenth example of the electromagnetic-coupling module.
Fig. 30 is an exploded perspective view showing a feeder circuit board of the sixteenth example.
Fig. 31 is an exploded perspective view showing a seventeenth example of the electromagnetic-coupling module.
Fig. 32 is a bottom view of a feeder circuit board of the seventeenth example, on which a wireless IC chip is mounted.
Fig. 33 is a side view of the seventeenth example.
Fig. 34 is a side view showing a modification of the seventeenth example.
Fig. 35 is an exploded perspective view showing an eighteenth example of the electromagnetic-coupling module.
Fig. 36 is a perspective view showing a first embodiment of an article with an electromagnetic-coupling module according to the present invention.
Fig. 37 is a perspective view showing a second embodiment of the article with an electromagnetic-coupling module according to the present invention.
Fig. 38 is a front view showing a third embodiment of the article with an electromagnetic-coupling module according to the present invention.
Fig. 39 is a perspective view showing a fourth embodiment of the article with an electromagnetic-coupling module according to the present invention.
Fig. 40 is a perspective view showing a fifth embodiment of the article with an electromagnetic-coupling module according to the present invention.
Fig. 41 is a perspective view showing a sixth embodiment of the article with an electromagnetic-coupling module according to the present invention.
Fig. 42 is a perspective view showing a seventh embodiment of the article with an electromagnetic-coupling module according to the present invention.
Fig. 43 is a perspective view showing an eighth embodiment of the article with an electromagnetic-coupling module according to the present invention.
Fig. 44 is a front view showing a ninth embodiment of the article with an electromagnetic-coupling module according to the present invention.
Fig. 45 is a perspective view showing a tenth embodiment of the article with an electromagnetic-coupling module according to the present invention.
Fig. 46 is a plan view showing an eleventh embodiment of the article with an electromagnetic-coupling module according to the present invention.
Fig. 47 is a perspective view showing a twelfth embodiment of the article with an electromagnetic-coupling module according to the present invention.
Fig. 48 is a perspective view showing a thirteenth embodiment of the article with an electromagnetic-coupling module according to the present invention.
Fig. 49 is a perspective view showing a fourteenth embodiment of the article with an electromagnetic-coupling module according to the present invention.
Fig. 50 is a perspective view showing a fifteenth embodiment of the article with an electromagnetic-coupling module according to the present invention.
Fig. 51 is a perspective view showing a sixteenth embodiment of the article with an electromagnetic-coupling module according to the present invention.
Fig. 52 is a perspective view showing a seventeenth embodiment of the article with an electromagnetic-coupling module according to the present invention.
Fig. 53 is a perspective view showing an eighteenth embodiment of the article with an electromagnetic-coupling module according to the present invention.
Fig. 54 is a perspective view showing a nineteenth embodiment of the article with an electromagnetic-coupling module according to the present invention.
Fig. 55 is a perspective view showing a twentieth embodiment of the article with an electromagnetic-coupling module according to the present invention.
Fig. 56 is a perspective view showing a twenty-first embodiment of the article with an electromagnetic-coupling module according to the present invention.
Fig. 57 is a perspective view showing a twenty-second embodiment of the article with an electromagnetic-coupling module according to the present invention.
Fig. 58 is a front view showing a twenty-third embodiment of the article with an electromagnetic-coupling module according to the present invention.
Fig. 59 is a perspective view showing a twenty-fourth embodiment of the article with an electromagnetic-coupling module according to the present invention.
Fig. 60 is a plan view showing a first example of a conventional wireless IC device.
Fig. 61 is a plan view showing a second example of a conventional wireless IC device.

### Best Mode for Carrying Out the Invention

Embodiments of an article with an electromagnetic-coupling module according to the present invention will be described below with reference to the attached drawings. Common components and parts of various electromagnetic-coupling modules and various articles to be described below are designated with the same reference numerals, and repetitious descriptions thereof are omitted.

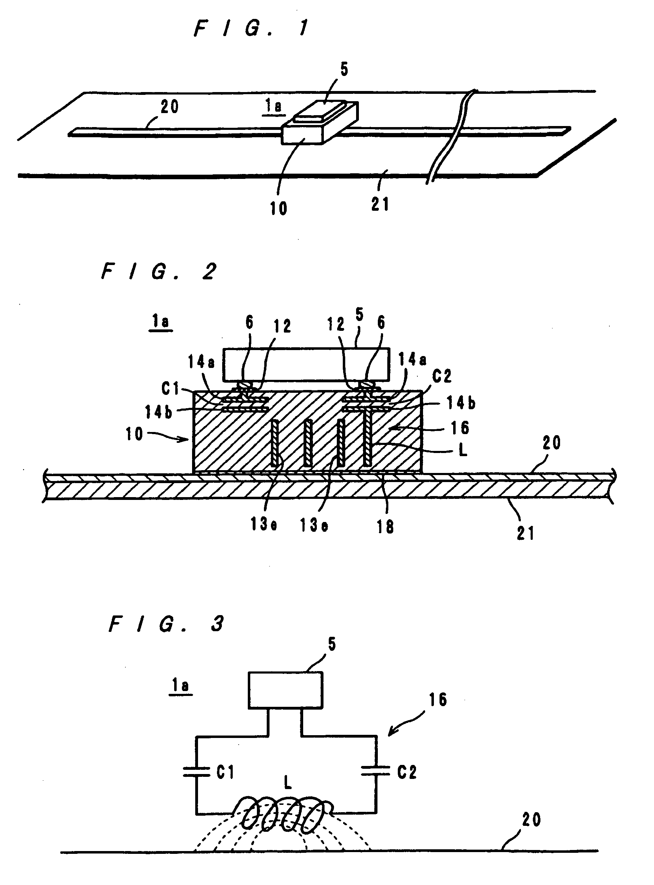

### (First example of Electromagnetic-Coupling Module, See Figs. 1 to 5)

An electromagnetic-coupling module 1a of a first example is combined with a monopole-type radiation plate 20. As shown in Figs. 1 and 2, the electromagnetic-coupling module 1a includes a wireless IC chip 5 and a feeder circuit board 10 with the wireless IC chip 5 mounted on the top surface, and is bonded to the radiation plate 20. The wireless IC chip 5 includes a clock circuit, a logic circuit, and a memory circuit in which necessary information is memorized. The wireless IC chip 5 is directly connected electrically to a feeder circuit 16 contained in the feeder circuit board 10.

The feeder circuit 16 is a circuit for supplying a transmission signal having a predetermined frequency to the radiation plate 20 and/or a circuit for selecting a received signal having a predetermined frequency from signals received by the radiation plate 20 and supplying the selected signals to the wireless IC chip 5. The feeder circuit 16 includes a resonance circuit that resonates at the frequency of transmission/received signals.

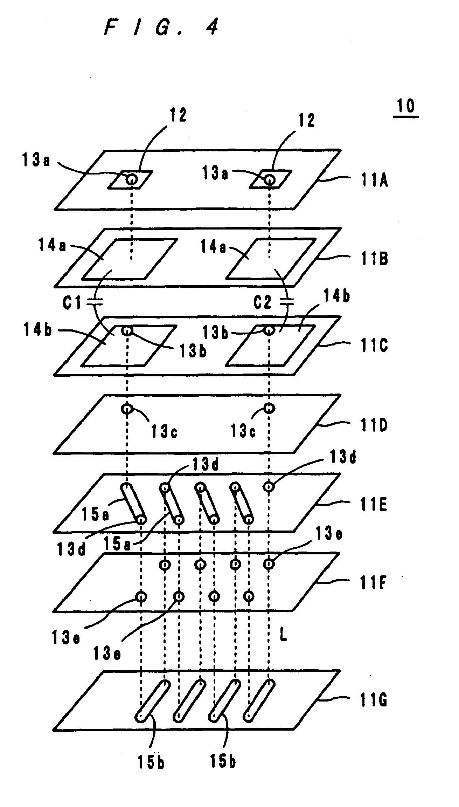

In the feeder circuit board 10, as shown in Figs. 2 and 3, the feeder circuit 16 is defined by a lumped-constant-type LC series resonance circuit formed of a helical inductance element L and capacitance elements C1 and C2. More specifically, as shown in Fig. 4, the feeder circuit board 10 is obtained by laminating, press-bonding and sintering ceramic sheets 11A to 11G made of a dielectric. The feeder circuit board 10 includes a sheet 11A on which connection electrodes 12 and viahole conductors 13a are formed; a sheet 11B on which capacitor electrodes 14a are formed; a sheet 11C on which capacitor electrodes 14b and viahole conductors 13b are formed; a sheet 11D on which viahole conductors 13c are formed; a sheet 11E on which conductor patterns 15a and viahole conductors 13d are formed; a sheet 11F (one or more) on which viahole conductors 13e are formed; and a sheet 11G on which conductor patterns 15b are formed. Each of the ceramic sheets 11A to 11G may be a sheet made of a magnetic ceramic material. The feeder circuit board 10 can be easily obtained by conventionally used processes for manufacturing a multilayer board, such as a sheet stacking method and a thick-film printing method.

As a result of stacking the above sheets 11A to 11G, the inductance element L whose helical winding axis is parallel to the radiation plate 20, and the capacitance elements C1 and C2 are formed. The capacitor electrode 14b is connected to both ends of the inductance element L, and the capacitor electrodes 14a are connected to the connection electrodes 12 via the viahole conductors 13a. Then, the connection electrodes 12, which serve as a board-side electrode pattern, are directly connected to a chip-side electrode pattern (not shown) of the wireless IC chip 5 via solder bumps 6 for electrical connection.

That is, a transmission signal is fed to the radiation plate 20 via a magnetic field from the inductance element L that is a coil-shaped electrode pattern, among the elements constituting the feeder circuit. Furthermore, a signal received from the radiation plate 20 is fed to the inductance element L via a magnetic field. To this end, in the feeder circuit board 10, preferably, the inductance element and the capacitance element constituting the resonance circuit are arranged such that the inductance element is nearer the radiation plate 20.

In this example, the radiation plate 20 is a long plate made of a non-magnetic material, such as aluminum foil or copper foil, that is, an open-ended metal material. The radiation plate 20 is formed on an article having a base of an insulating flexible resin film 21, such as PET. The feeder circuit board 10 is bonded to the radiation plate 20 via an insulating adhesive layer which is an adhesive agent 18 applied to the bottom of the feeder circuit board 10.

An example in terms of their size will be given. The thickness of the wireless IC chip 5 is 50 µm to 100 µm. The thickness of the solder bumps 6 is approximately 20 µm. The thickness of the feeder circuit board 10 is 200 µm to 500 µm. The thickness of the adhesive agent 18 is 0.1 µm to 10 µm. The thickness of the radiation plate 20 is 1 µm to 50 µm. The thickness of the film 21 is 10 µm to 100 µm. The size (area) of the wireless IC chip 5 has various values, such as 0.4 mm x 0.4 mm and 0. 9 mm x 0.8 mm. The size (area) of the feeder circuit board 10 can range from the same size as that of the wireless IC chip 5 to approximately 3 mm x 3 mm.

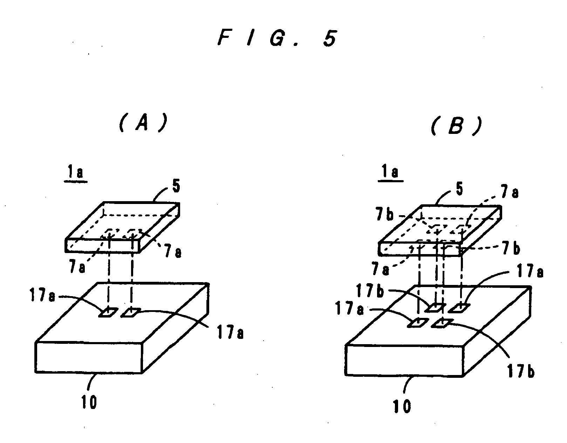

Fig. 5 shows connection arrangement between the wireless IC chip 5 and the feeder circuit board 10. Fig. 5(A) shows an arrangement in which pairs of antenna (balance) terminals 7a and 17a are formed on the reverse surface of the wireless IC chip 5 and on the obverse surface of the feeder circuit board 10. Fig. 5(B) shows another arrangement in which in addition to the pairs of antenna (balance) terminals 7a and 17a, ground terminals 7b and 17b are provided on the reverse surface of the wireless IC chip 5 and on the obverse surface of the feeder circuit board 10. However, the ground terminals 17b on the surface of the feeder circuit board 10 are terminated and are not connected to other elements in the feeder circuit board 10.

Fig. 3 shows an equivalent circuit of the electromagnetic-coupling module 1a. In the electromagnetic-coupling module 1a, a high-frequency signal (for example, a UHF frequency band) emitted from a reader/writer (not shown) is received by the radiation plate 20, and the feeder circuit 16 (the LC series resonance circuit formed of the inductance element L and the capacitance elements C1 and C2) that is mainly magnetically coupled with the radiation plate 20 is caused to resonate. Thereby, a received signal at a predetermined frequency band is supplied to the wireless IC chip 5. On the other hand, predetermined energy is extracted from the received signal, and at the feeder circuit 16, by using the energy as a driving source, the information memorized in the wireless IC chip 5 is matched with a predetermined frequency. Thereafter, a transmission signal is transmitted from the inductance element L of the feeder circuit 16 to the radiation plate 20 via magnetic coupling, and is transmitted and transferred from the radiation plate 20 to the reader/writer.

The coupling between the feeder circuit 16 and the radiation plate 20 is mainly coupling via a magnetic field. However, coupling via an electric field may exist. In the present invention, "electromagnetic coupling" means coupling via an electric field and/or a magnetic field.

In the electromagnetic-coupling module 1a of the first example, the wireless IC chip 5 is directly connected electrically to the feeder circuit board 10 containing the feeder circuit 16, and the feeder circuit board 10 has almost the same area as that of the wireless IC chip 5 and is rigid. Therefore, as compared with a conventional case in which the wireless IC chip 5 is mounted on a large flexible film, the wireless IC chip 5 can be positioned and mounted extremely accurately. Moreover, since the feeder circuit board 10 is made of a ceramic material and has a heat resistance characteristic, it is possible to solder the wireless IC chip 5 to the feeder circuit board 10. That is, since an ultra-sonic bonding method is not used, unlike the conventional case, the cost is reduced, and there is no risk that the wireless IC chip 5 is damaged by pressure applied at the time of ultra-sonic bonding. Further, it is possible to use a self-alignment effect resulting from a solder reflow.

In the feeder circuit 16, resonance frequency characteristics are determined by a resonance circuit formed of the inductance element L and the capacitance elements C1 and C2. The resonance frequency of a signal emitted from the radiation plate 20 substantially corresponds to the self-resonance frequency of the feeder circuit 16, and the maximum gain of the signal is substantially determined by at least one of the size and shape of the feeder circuit 16 and the distance and medium between the feeder circuit 16 and the radiation plate 20. More specifically, in the first example, the electrical length of the radiation plate 20 is set to 1/2 of the resonance frequency λ. However, the electrical length of the radiation plate 20 may not be an integral multiple of λ/2. That is, in the present invention, since the frequency of the signal emitted from the radiation plate 20 is substantially determined by the resonance frequency of the resonance circuit (the feeder circuit 16), frequency characteristics do not substantially depend on the electrical length of the radiation plate 20. When the electrical length of the radiation plate 20 is an integral multiple of λ/2, the gain becomes maximum, which is desirable.

In the manner described above, since the resonance frequency characteristics of the feeder circuit 16 are determined by the resonance circuit formed of the inductance element L and the capacitance elements C1 and C2 contained in the feeder circuit board 10, the resonance frequency characteristics do not change even if the electromagnetic-coupling module 1a is inserted in a book. Furthermore, even if the shape of the radiation plate 20 is changed by rounding the electromagnetic-coupling module 1a or even if the size of the radiation plate 20 is changed, the resonance frequency characteristics do not change. Furthermore, since the coil-shaped electrode pattern constituting the inductance element L is formed in such a manner that the winding axis thereof is parallel to the radiation plate 20, the electromagnetic-coupling module 1a has the advantage that the center frequency does not change. Furthermore, since the capacitance elements C1 and C2 are inserted downstream of the wireless IC chip 5, the elements C1 and C2 to cut surge at a low frequency band, and it is possible to protect the wireless IC chip 5 against surge.

Furthermore, since the feeder circuit board 10 is a rigid multilayer board, it is easy to handle for soldering of the wireless IC chip 5. Moreover, since the radiation plate 20 is a flexible metal film, for example, it is possible to form the radiation plate 20 on a wrapping film for clothes or on the surface of a columnar body, such as a plastic bottle, without difficulty.

In the present invention, the resonance circuit may also serve as a matching circuit for matching the impedance of the wireless IC chip with the impedance of the radiation plate. Alternatively, the feeder circuit board may further include a matching circuit, which is formed of an inductance element and a capacitance element, separately from the resonance circuit. If the function of the matching circuit is added to the resonance circuit, the design of the resonance circuit tends to be complicated. If the matching circuit is provided separately from the resonance circuit, the resonance circuit and the matching circuit can be designed independently of each other.

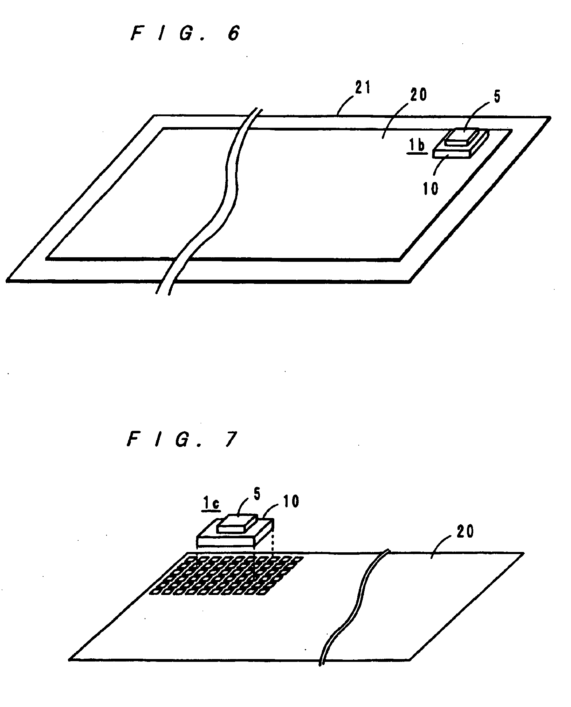

### (Second Example of Electromagnetic-Coupling Module, See Fig. 6)

As shown in Fig. 6, an electromagnetic-coupling module 1b of a second example is mounted on a radiation plate 20 made of aluminum foil having a large area, and the radiation plate 20 is fixed on an article having a base made of a flexible insulating plastic film 21 having a large area. The feeder circuit board 10 with a wireless IC chip 5 mounted thereon is bonded at an arbitrary position of the radiation plate 20.

The configuration of the electromagnetic-coupling module 1b, that is, the internal configuration of the feeder circuit substrate 10, is the same as that of the first example. Therefore, the operation and effect of the second example are basically the same as those of the first example. Further, the electromagnetic-coupling module 1b has an advantage that high accuracy is not necessary for positioning of the feeder circuit board 10 on the radiation plate 20.

### (Third Example of Electromagnetic-Coupling Module, See Fig. 7)

As shown in Fig. 7, an electromagnetic-coupling module 1c of a third example is mounted on a meshed part of a large radiation plate 20 made of aluminum foil. The mesh may be formed on the entire surface of the radiation plate 20 or may be formed on part of the radiation plate 20.

The configuration of the electromagnetic-coupling module is the same as that of the second example. In addition to the advantage that high accuracy is not required for the positioning of the feeder circuit board 10 on the radiation plate 20, since the magnetic flux of the coil-shaped electrode pattern passes through the openings of the mesh, changes (decreases) of the magnetic flux generated from the feeder circuit board 10 are decreased, and a larger amount of magnetic flux can pass through the radiation plate 20. Therefore, it is possible to improve the transfer efficiency of signal energy, and it is also possible to reduce a shift of frequency due to laminating.

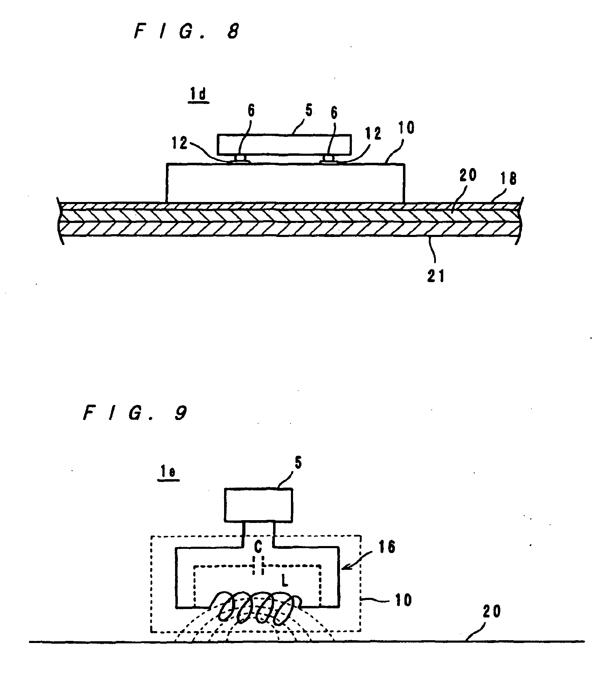

### (Fourth Example of Electromagnetic-Coupling Module, See Fig. 8)

As shown in Fig. 8, in an electromagnetic-coupling module 1d, an adhesive agent 18 is applied to the film 21, which is a base of the article to which the electromagnetic-coupling module 1d is attached, on the surface on which the feeder circuit board 10 is mounted, including the bonding position of the board 10 and other portions (here, on the entire surface). The adhesive agent 18 enables an article including the electromagnetic-coupling module 1d to be bonded to another article with the electromagnetic-coupling module 1d inside.

The configuration of the electromagnetic-coupling module 1d, that is, the internal configuration of the feeder circuit board 10, is the same as that of the first example. Therefore, the operation and effect of the fourth example are basically the same as those of the first example.

### (Fifth Example of Electromagnetic-Coupling Module, See Fig. 9)

As shown as an equivalent circuit in Fig. 9, an electromagnetic-coupling module 1e of a fifth example includes an inductance element L defined by a coil-shaped electrode pattern as a feeder circuit 16 in a feeder circuit board 10. A capacitance element C constituting an LC parallel resonance circuit is formed as a floating capacitance (distributed-constant-type capacitance) between conductor patterns of the inductance element L.

That is, even in the case of one coil-shaped electrode pattern, if it has self-resonance, the L component of the coil-shaped electrode pattern and the C component that is a floating capacitance between wires form an LC parallel resonance circuit to configure the feeder circuit 16. Therefore, in the electromagnetic-coupling module 1e, a high-frequency signal (for example, a UHF frequency band) emitted from a reader/writer (not shown) is received at the radiation plate 20, and the feeder circuit 16 (the LC parallel resonance circuit formed of an inductance element L and a capacitance element C) that is mainly magnetically coupled with the radiation plate 20 is caused to resonate. Thereby, a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted from the inductance element L of the feeder circuit 16 to the radiation plate 20 via magnetic coupling. Then, the transmission signal is transmitted and transferred from the radiation plate 20 to the reader/writer.

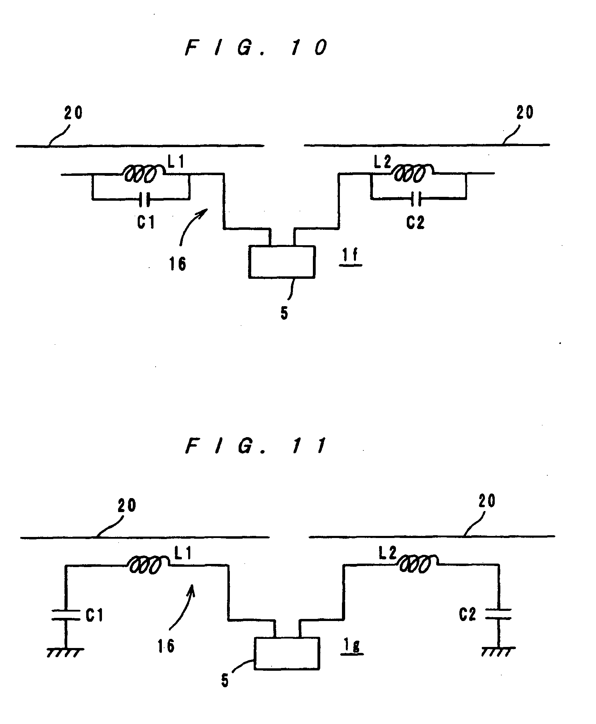

### (Sixth Example of Electromagnetic-Coupling Module, See Fig. 10)

As shown as an equivalent circuit in Fig. 10, an electromagnetic-coupling module 1f of a sixth example includes a feeder circuit 16 compatible with dipole-type radiation plates 20. The feeder circuit 16 is formed of two LC parallel resonance circuits contained in a feeder circuit board. An inductance element L1 and a capacitance element C1 are connected to a first port side of the wireless IC chip 5, and an inductance element L2 and a capacitance element C2 are connected to a second port side of the wireless IC chip 5. The pairs of the inductance element and the capacitance element face the radiation plates 20, respectively. The inductance element L1 and the capacitance element C1 have open ends. The first port and the second port constitute I/O of a differential circuit.

The operation and effect of the sixth example are basically the same as those of the first example. That is, in the electromagnetic-coupling module 1f, a high-frequency signal (for example, a UHF frequency band) emitted from a reader/writer (not shown) is received at the radiation plates 20, and the feeder circuit 16 (the LC parallel resonance circuit formed of the inductance element L1 and the capacitance element C1, and the LC parallel resonance circuit formed of the inductance element L2 and the capacitance element C2) that is mainly magnetically coupled with the radiation plates 20 is caused to resonate. Thereby, only a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted from the inductance elements L1 and L2 of the feeder circuit 16 to the radiation plates 20 via magnetic coupling. Then, the transmission signal is transmitted and transferred from the radiation plate 20 to the reader/writer.

### (Seventh Example of Electromagnetic-Coupling Module, See Fig. 11)

As shown as an equivalent circuit in Fig. 11, an electromagnetic-coupling module 1g of a seventh example includes a feeder circuit 16 compatible with dipole-type radiation plates 20. The feeder circuit 16 is formed of two LC series resonance circuits contained in a feeder circuit board. Inductance elements L1 and L2 face radiation plates 20 and 20, respectively, and capacitance elements C1 and C2 are grounded.

The operation and effect of the seventh example are basically the same as those of the first example. That is, in the electromagnetic-coupling module 1g, a high-frequency signal (for example, a UHF frequency band) emitted from a reader/writer (not shown) is received at the radiation plates 20, and the feeder circuit 16 (the LC series resonance circuit formed of the inductance element L1 and the capacitance element C1, and the LC series resonance circuit formed of the inductance element L2 and the capacitance element C2) that is mainly magnetically coupled with the radiation plates 20 is caused to resonate. Thereby, only a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted from the inductance elements L1 and L2 of the feeder circuit 16 to the radiation plates 20 via magnetic coupling. Then, the transmission signal is transmitted and transferred from the radiation plates 20 to the reader/writer.

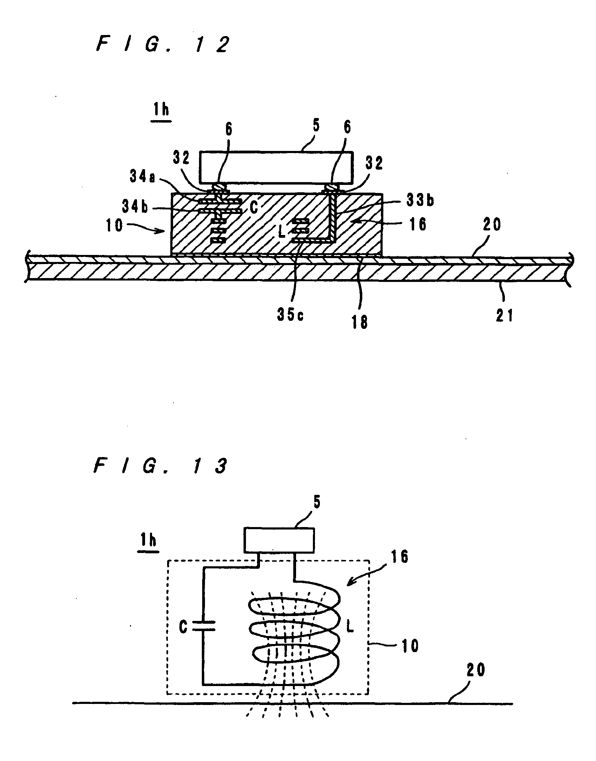

### (Eighth Example of Electromagnetic-Coupling Module, See Figs. 12 to 14)

As shown in Fig. 12, an electromagnetic-coupling module 1h of an eighth example is combined with a monopole-type radiation plate 20. The electromagnetic-coupling module 1h includes a feeder circuit 16 defined by an LC series resonance circuit formed of an inductance element L and a capacitance element C contained in a feeder circuit board 10. As shown in Fig. 13, a coil-shaped electrode pattern constituting the inductance element L has a winding axis perpendicular to the radiation plate 20, and the feeder circuit 16 is mainly magnetically coupled with the radiation plate 20.

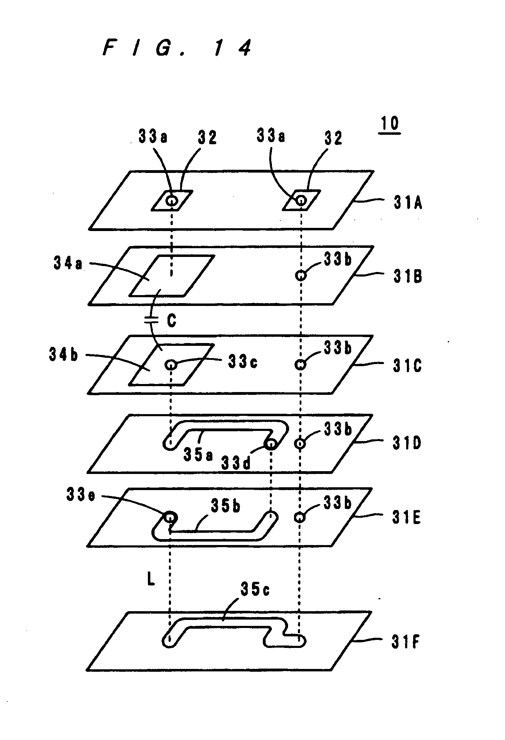

More specifically, as shown in Fig. 14, the feeder circuit board 10 is obtained by laminating, press-bonding and sintering ceramic sheets 31A to 31F made of a dielectric. The feeder circuit board 10 includes a sheet 31A on which connection electrodes 32 and viahole conductors 33a are formed; a sheet 31B on which a capacitor electrode 34a and a viahole conductor 33b are formed; a sheet 31C on which a capacitor electrode 34b and viahole conductors 33c and 33b are formed; a sheet 31D (one or more) on which a conductor pattern 35a and viahole conductors 33d and 33b are formed; a sheet 31E (one or more) on which a conductor pattern 35b and viahole conductors 33e and 33b are formed; and a sheet 31F on which a conductor pattern 35c is formed.

By stacking the above sheets 31A to 31F, the feeder circuit 16 is formed as an LC series resonance circuit, in which the inductance element L whose helical winding axis is perpendicular to the radiation plate 20 is connected in series with the capacitance element C, is obtained. The capacitor electrode 34a is connected to the connection electrode 32 via the viahole conductor 33a and is further connected to the wireless IC chip 5 via a solder bump 6. One end of the inductance element L is connected to the connection electrode 32 via the viahole conductor 33b and is further connected to the wireless IC chip 5 via a solder bump 6.

The operation and effect of the eighth example are basically the same as those of the first example. That is, in the electromagnetic-coupling module 1h, a high-frequency signal (for example, a UHF frequency band) emitted from a reader/writer (not shown) is received at the radiation plate 20, and the feeder circuit 16 (the LC series resonance circuit formed of an inductance element L and a capacitance element C) that is mainly magnetically coupled with the radiation plate 20 is caused to resonate. Thereby, only a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted from the inductance element L of the feeder circuit 16 to the radiation plate 20 via magnetic coupling. Then, the transmission signal is transmitted and transferred from the radiation plate 20 to the reader/writer.

In particular, in the eighth example, since the coil-shaped electrode pattern has a winding axis perpendicular to the radiation plate 20, the eighth example has an advantage that the magnetic flux to the radiation plate 20 increases. Consequently, the transfer efficiency of signal energy is improved, and the gain is increased.

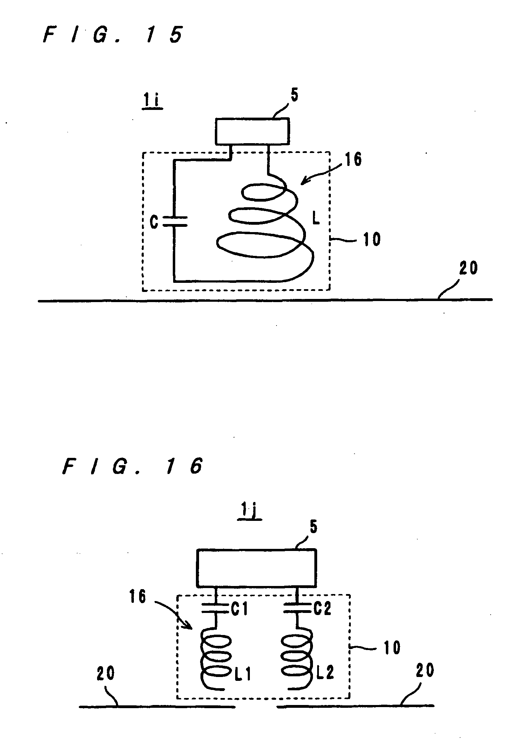

### (Ninth Example of Electromagnetic-Coupling Module, See Fig. 15)

As shown as an equivalent circuit in Fig. 15, in an electromagnetic-coupling module 1i of a ninth example, an inductance element L has a coil-shaped electrode pattern as described in the eighth example, and the coil-shaped electrode pattern has a winding width (coil diameter) which becomes gradually larger toward the radiation plate 20. Other configurations are the same as those of the eighth example.

The ninth example exhibits the same operation and effect as those of the eighth example. In addition, since the winding width (coil diameter) of the coil-shaped electrode pattern of the inductance element L is gradually larger toward the radiation plate 20, the transfer efficiency of signals is improved.

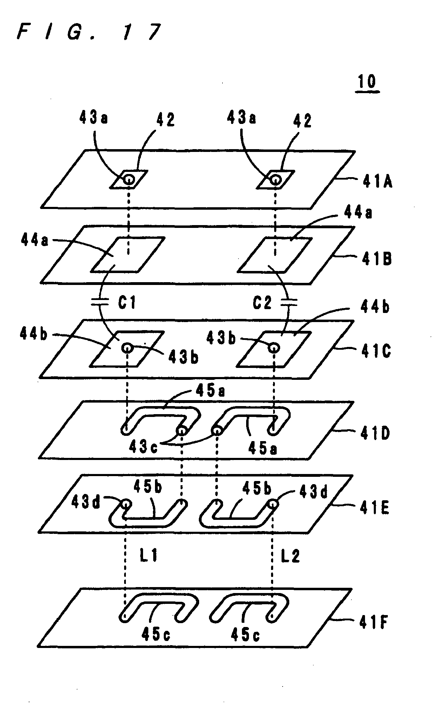

### (Tenth Example of Electromagnetic-Coupling Module, See Figs. 16 and 17)

As shown as an equivalent circuit in Fig. 16, an electromagnetic-coupling module 1j of a tenth example is compatible with dipole-type radiation plates 20 and contains a feeder circuit 16 defined by two LC series resonance circuits in a feeder circuit board 10.

More specifically, as shown in Fig. 17, the feeder circuit board 10 is obtained by laminating, press-bonding and sintering ceramic sheets 41A to 41F made of a dielectric. The feeder circuit board 10 includes a sheet 41A on which connection electrodes 42 and viahole conductors 43a are formed; a sheet 41B on which capacitor electrodes 44a are formed; a sheet 41C on which capacitor electrodes 44b and viahole conductors 43b are formed; a sheet 41D (one or more) on which conductor patterns 45a and viahole conductors 43c are formed; a sheet 41E (one or more) on which conductor patterns 45b and viahole conductors 43d are formed; and a sheet 41F on which conductor patterns 45c are formed.

By stacking the above sheets 41A to 41F, the feeder circuit 16 is defined by two LC series resonance circuits, in which the inductance elements L1 and L2 having helical winding axes perpendicular to the radiation plates 20 and are connected in series with the capacitance elements C1 and C2, respectively. The capacitor electrodes 44a are connected to the connection electrode 42 via the viahole conductors 43a and are further connected to the wireless IC chip 5 via solder bumps.

The operation and effect of the tenth example are basically the same as those of the first example. That is, in the electromagnetic-coupling module 1j, a high-frequency signal (for example, a UHF frequency band) emitted from a reader/writer (not shown) is received at the radiation plate 20, and the feeder circuit 16 (the LC series resonance circuit formed of an inductance element L1 and a capacitance element C1, and the LC series resonance circuit formed of an inductance element L2 and a capacitance element C2) that is mainly magnetically coupled with the radiation plates 20 is caused to resonate. Thereby, a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted from the inductance elements L1 and L2 of the feeder circuit 16 to the radiation plate 20 via magnetic coupling. Then, the transmission signal is transmitted and transferred from the radiation plate 20 to the reader/writer.

Furthermore, since the capacitance elements C1 and C2 are disposed downstream of the wireless IC chip 5 and between the wireless IC chip 5 and the inductance elements L1 and L2, surge resistance is improved. Since a surge is a low-frequency electric current up to 200 MHz, it is possible to cut the surge by the capacitance elements C1 and C2, and the wireless IC chip 5 is prevented from being destroyed by the surge.

In the tenth example, the resonance circuit formed of the capacitance element C1 and the inductance element L1 is not coupled to the resonance circuit formed of the capacitance element C2 and the inductance element L2.

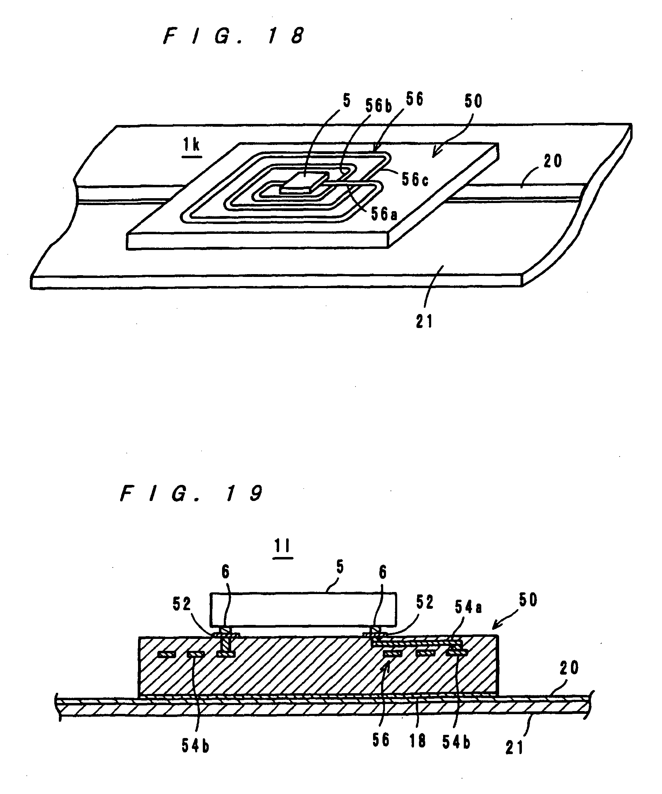

### (Eleventh Example of Electromagnetic-Coupling Module, See Fig. 18 not conforming to the invention)

As shown in Fig. 18, in an electromagnetic-coupling module 1k of an eleventh example, a feeder circuit 56 defined by a coil-shaped electrode pattern, that is, a spiral inductance element is provided on the surface of a rigid single-layer feeder circuit board 50 made of ceramic or heat-resistant resin. Both ends of the feeder circuit 56 are directly connected to a wireless IC chip 5 via solder bumps, and the feeder circuit board 50 is bonded to the film 21, which holds a radiation plate 20, by using an adhesive agent. A conductor pattern 56a and conductor patterns 56b and 56c, which constitute the feeder circuit 56 and which intersect each other, are separated by an insulating film (not shown).

The feeder circuit 56 of the eleventh example constitutes an LC parallel resonance circuit using a floating capacitance between spiral conductor patterns as a capacitance component. The feeder circuit board 50 is a single-layer board made of a dielectric or a magnetic material.

In the electromagnetic-coupling module 1k of the eleventh example, the feeder circuit 56 is mainly magnetically coupled with the radiation plate 20. Therefore, similarly to each of the above-described examples, a high-frequency signal emitted from a reader/writer is received at the radiation plate 20, and the feeder circuit 56 is caused to resonate. Thereby, only a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 56. Thereafter, a transmission signal is transmitted from the inductance element of the feeder circuit 56 to the radiation plate 20 via magnetic coupling. Then, the transmission signal is transmitted and transferred from the radiation plate 20 to the reader/writer.

Similarly to the first example, the positioning accuracy of the wireless IC chip 5 is satisfactory since the wireless IC chip 5 is provided on the small rigid feeder circuit board 50. The wireless IC chip 5 can be connected to the feeder circuit board 50 by using solder bumps.

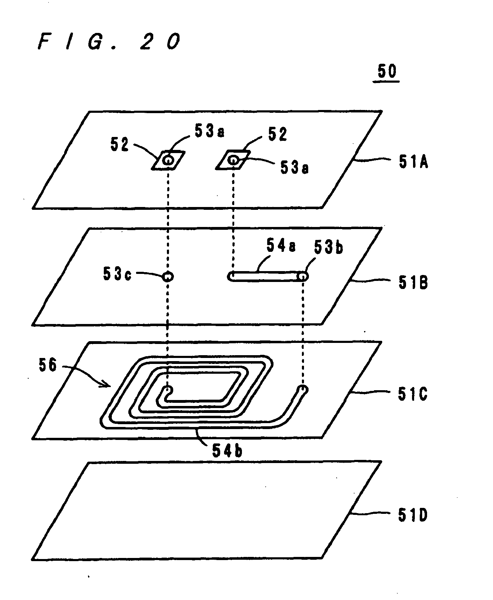

### (Twelfth Example of Electromagnetic-Coupling Module, see Figs. 19 and 20)

As shown in Fig. 19, an electromagnetic-coupling module 11 of a twelfth example includes a feeder circuit 56 defined by a coil-shaped electrode pattern contained in a feeder circuit board 50. As shown in Fig. 20, the feeder circuit board 50 is obtained by laminating, press-bonding and sintering ceramic sheets 51A to 51D made of a dielectric. The feeder circuit board 50 includes a sheet 51A on which connection electrodes 52 and viahole conductors 53a are formed; a sheet 51B on which a conductor pattern 54a and viahole conductors 53b and 53c are formed; a sheet 51C on which a conductor pattern 54b is formed; and a plain sheet 51D (one or more).

By stacking the above sheets 51A to 51D, the feeder circuit board 50, in which the feeder circuit 56 is defined by a resonance circuit formed of a spiral inductance element and a capacitance component formed by a floating capacitance between wires of the spiral conductors, is obtained. The connection electrodes 52 positioned at both ends of the feeder circuit 56 are connected to the wireless IC chip 5 via solder bumps 6. The operation and effect of the twelfth example are the same as those of the eleventh example.

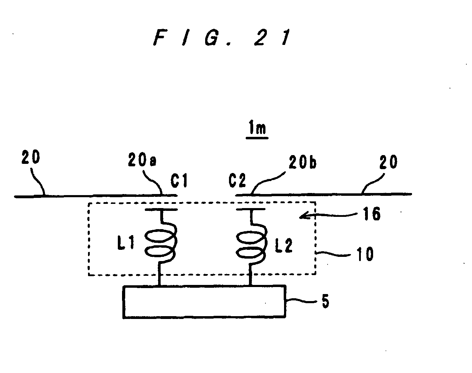

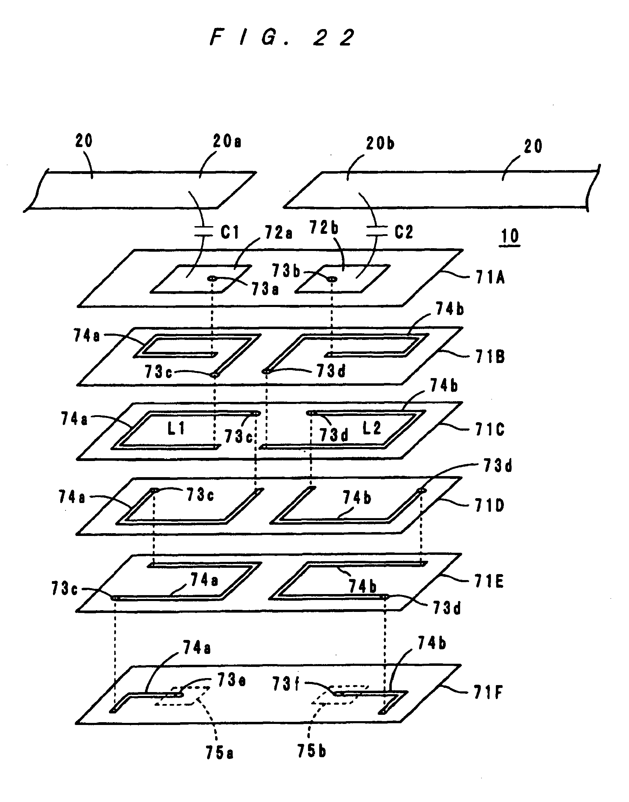

### (Thirteenth Example of Electromagnetic-Coupling Module, See Figs. 21 and 22)

As shown as an equivalent circuit in Fig. 21, in an electromagnetic-coupling module 1m of a thirteenth example, a feeder circuit board 10 is capacitively coupled with radiation plates 20. The feeder circuit board 10 contains a feeder circuit 16 formed of two LC series resonance circuits. Respective one ends of inductance elements L1 and L2 are connected to a wireless IC chip 5, and the other ends are connected to capacitor electrodes 72a and 72b (see Fig. 22) defining capacitance elements C1 and C2 provided on the surface of the board 10. End portions 20a and 20b of the radiation plate 20 function as the other capacitor electrodes constituting the capacitance elements C1 and C2.

More specifically, as shown in Fig. 22, the feeder circuit board 10 is obtained by laminating, press-bonding and sintering ceramic sheets 71A to 71F made of a dielectric. The feeder circuit substrate 10 includes a sheet 71A on which capacitor electrodes 72a and 72b and viahole conductors 73a and 73b are formed; sheets 71B to 71E on which conductor patterns 74a and 74b and viahole conductors 73c and 73d are formed; and a sheet 71F, on one surface of which conductor patterns 74a and 74b are formed and on the other surface of which connection electrodes 75a and 75b are formed, the conductor patterns 74a and 74b being connected to the connection electrodes 75a and 75b by viahole conductors 73e and 73f, respectively.

By stacking the above sheets 71A to 71F, the feeder circuit 16 is defined by twc LC series resonance circuits, in which the inductance elements L1 and L2 are connected in series with the capacitance elements C1 and C2. By bonding the feeder circuit board 10 to the radiation plates 20 by an adhesive agent, the capacitor electrodes 72a and 72b, which are planar electrode patterns disposed in parallel to the radiation plates 20, face the end portions 20a and 20b of the radiation plate 20 via the insulating adhesive layer, and the capacitance elements C1 and C2 are defined. By bonding the electrodes 75a and 75b to the wireless IC chip 5 via solder bumps, one end of each of the inductance elements L1 and L2 is connected to the wireless IC chip 5, and thereby, the wireless IC chip 5 and the feeder circuit substrate 10 are directly connected electrically to each other.

When the bonding agent contains, for example, dielectric powder, the bonding layer has properties as a dielectric, and accordingly, the capacitance of the capacitance elements C1 and C2 increases. In the thirteenth example, the capacitor electrodes 72a and 72b, that are second board-side electrode patterns, are formed on the reverse surface of the feeder circuit board 10. The capacitor electrodes 72a and 72b may be formed inside the feeder circuit board 10 (at a portion closer to the radiation plate 20). The capacitor electrodes 72a and 72b may also be provided in the internal layer of the board 10.

The operation and effect of the thirteenth example are basically the same as those of the first example. That is, in the electromagnetic-coupling module 1m, a high-frequency signal (for example, a UHF frequency band) emitted from a reader/writer (not shown) is received at the radiation plate 20, and the feeder circuit 16 (the LC series resonance circuit formed of an inductance element L1 and a capacitance element C1, and the LC series resonance circuit formed of an inductance element L2 and a capacitance element C2) that is capacitively coupled with the radiation plate 20 is caused to resonate. Thereby, only a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted to the radiation plate 20 via capacitive coupling formed by the capacitance elements C1 and C2. Then, the transmission signal is transmitted and transferred from the radiation plate 20 to the reader/writer.

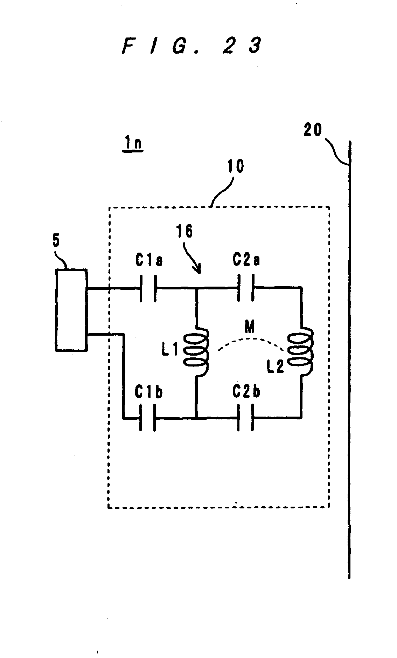

### (Fourteenth Example of Electromagnetic-Coupling Module, See Figs. 23 to 25)

As shown as an equivalent circuit in Fig. 23, in an electromagnetic-coupling module In of a fourteenth example, a feeder circuit 16 includes inductance elements L1 and L2 that are magnetically coupled with each other. The inductance element L1 is connected to a wireless IC chip 5 via capacitance elements C1a and C1b, and is connected in parallel with the inductance element L2 via capacitance elements C2a and C2b. In other words, the feeder circuit 16 is configured to include an LC series resonance circuit formed of the inductance element L1 and the capacitance elements C1a and C1b, and an LC series resonance circuit formed of the inductance element L2 and the capacitance elements C2a and C2b. The resonance circuits are coupled with each other by magnetic coupling indicated by M in Fig. 23. Both the inductance element L1 and L2 are magnetically coupled with a radiation plate 20.

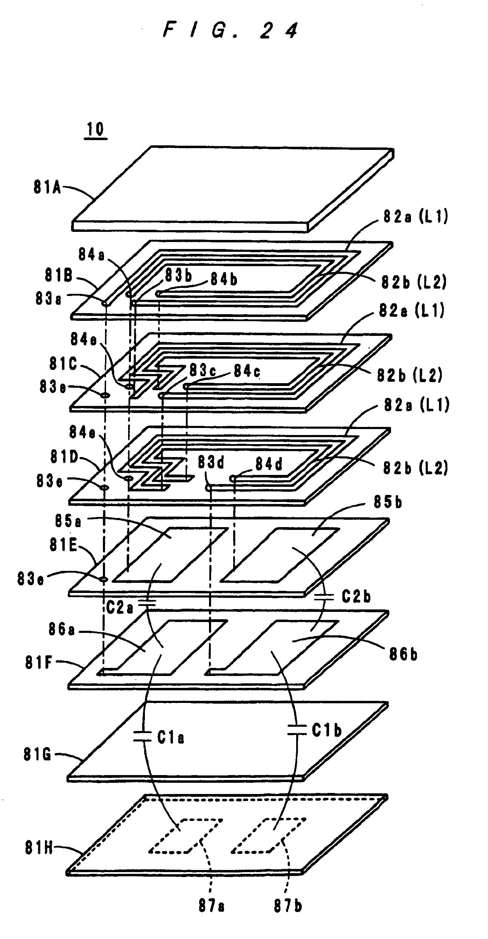

More specifically, as shown in Fig. 24, a feeder circuit board 10 is obtained by laminating, press-bonding and sintering ceramic sheets 81A to 81H made of a dielectric. The feeder circuit board 10 includes a plain sheet 81A; a plain sheet 81B on which conductor patterns 82a and 82b and viahole conductors 83a 83b, 84a, and 84b are formed; a sheet 81C on which conductor patterns 82a and 82b and viahole conductors 83c, 84c, 83e, and 84e are formed; a sheet 81D on which conductor patterns 82a and 82b and viahole conductors 83d, 84d, 83e, and 84e are formed; a sheet 81E on which capacitor electrodes 85a and 85b and a viahole conductor 83e are formed; a sheet 81F on which capacitor electrodes 86a and 86b are formed; a plain sheet 81G; and a sheet 81H on which capacitor electrodes 87a and 87b are formed on its reverse surface.

By stacking the above sheets 81A to 81H, the conductor patterns 82a are connected via the viahole conductors 83b and 83c, thereby forming the inductance element L1, and the conductor patterns 82b are connected via the viahole conductors 84b and 84c, thereby forming the inductance element L2. The capacitor electrodes 86a and 87a form the capacitance element C1a, and the capacitor electrode 86a is connected to one end of the inductance element L1 via the viahole conductor 83e. The capacitor electrodes 86b and 87b form the capacitance element C1b, and the capacitor electrode 86b is connected to the other end of the inductance element L1 via the viahole conductor 83d. The capacitor electrodes 85a and 86a form the capacitance element C2a, and the capacitor electrode 85a is connected to one end of the inductance element L2 via the viahole conductor 84e. The capacitor electrodes 85b and 86b form the capacitance element C2b, and the capacitor electrode 85b is connected to the other end of the inductance element L2 via the viahole conductor 84d.

The operation and effect of the fourteenth example are basically the same as those of the first example. That is, in the electromagnetic-coupling module 1n, a high-frequency signal (for example, a UHF frequency band) emitted from a reader/writer (not shown) is received at the radiation plate 20, and the feeder circuit 16 (the LC series resonance circuit formed of an inductance element L1 and capacitance elements C1a and C1b, and the LC series resonance circuit formed of an inductance element L2 and a capacitance elements C2a and C2b) that is mainly magnetically coupled with the radiation plate 20 is caused to resonate. Thereby, only a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted from the inductance elements L1 and L2 of the feeder circuit 16 to the radiation plate 20 via magnetic coupling. Then, the transmission signal is transmitted and transferred from the radiation plate 20 to the reader/writer.

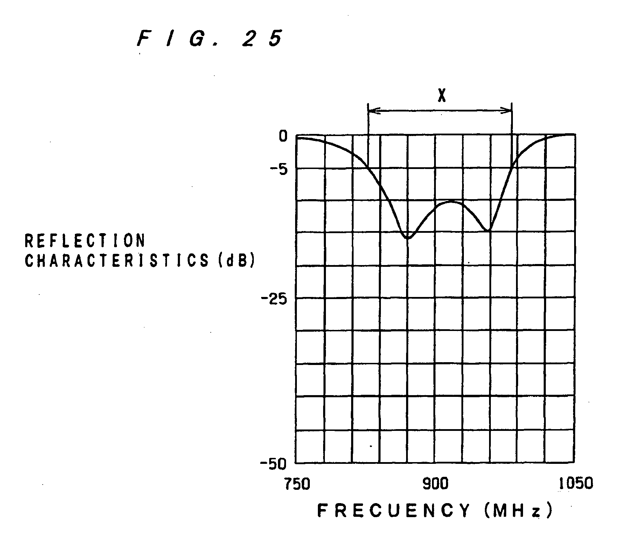

In particular, in the fourteenth example, regarding the reflection characteristics, the frequency band is wide as indicated as a bandwidth X in Fig. 25. This results from the fact that the feeder circuit 16 is configured by a plurality of LC resonance circuits including inductance elements L1 and L2 that are magnetically coupled with each other at a high degree of coupling. Furthermore, since the capacitance elements C1a and C1b are disposed at a stage subsequent to the wireless IC chip 5, surge resistance is improved.

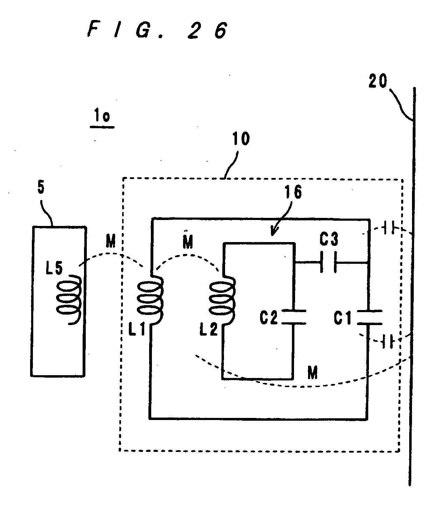

### (Fifteenth Example of Electromagnetic-Coupling Module, See Figs. 26 to 28)

As shown as an equivalent circuit in Fig. 26, in an electromagnetic-coupling module 1o of a fifteenth example, a feeder circuit 16 includes inductance elements L1 and L2 that are magnetically coupled with each other at a high degree of coupling. The inductance element L1 is magnetically coupled with an inductance element L5 provided in a wireless IC chip 5. The inductance element L2 and a capacitance element C2 form an LC series resonance circuit. Furthermore, a capacitance element C1 is capacitively coupled with a radiation plate 20, and another capacitance element C3 is disposed between the capacitance elements C1 and C2.

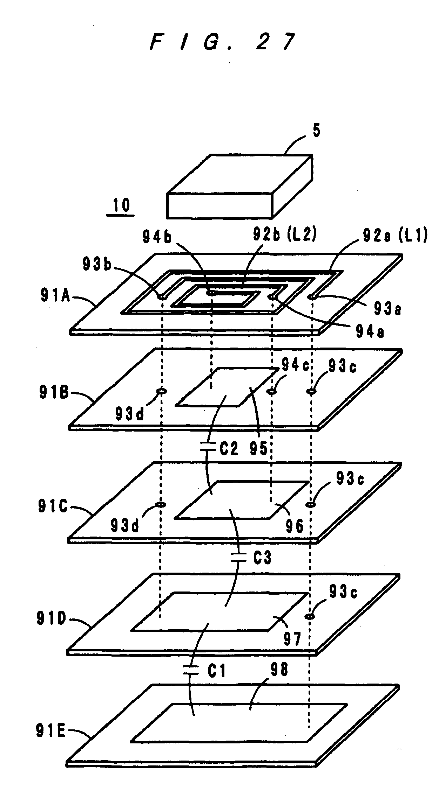

More specifically, as shown in Fig. 27, a feeder circuit board 10 is obtained by laminating, press-bonding and sintering ceramic sheets 91A to 91E. The feeder circuit board 10 includes a sheet 91A on which conductor patterns 92a and 92b and viahole conductors 93a, 93b, 94a, and 94b are formed; a sheet 91B on which a capacitor electrode 95 and viahole conductors 93c, 93d, and 94c are formed; a sheet 91C on which a capacitor electrode 96 and viahole conductors 93c and 93d are formed; a sheet 91D on which a capacitor electrode 97 and a viahole conductor 93c are formed; a sheet 91E on which a capacitor electrode 98 is formed.

By stacking these sheets 91A to 91E, the conductor pattern 92a forms an inductance element L1, and the conductor pattern 92b forms an inductance element L2. The capacitor electrodes 97 and 98 form the capacitance element C1. One end of the inductance element L1 is connected to the capacitor electrode 98 via the viahole conductors 93a and 93c, and the other end thereof is connected to the capacitor electrode 97 via the viahole conductors 93b and 93d. The capacitor electrodes 95 and 96 form the capacitance element C2. One end of the inductance element L2 is connected to the capacitor electrode 96 via the viahole conductors 94a and 94c, and the other end thereof is connected to the capacitor electrode 95 via the viahole conductor 94b. Furthermore, the capacitor electrodes 96 and 97 form the capacitance element C3.

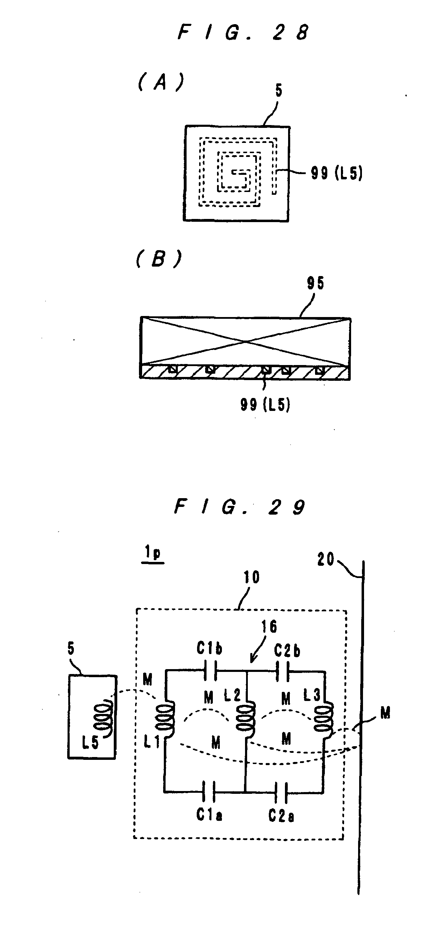

As shown in Fig. 28, a coil-shaped electrode pattern 99 is provided on the reverse surface of the wireless IC chip 5 as a chip-side electrode pattern, and the coil-shaped electrode pattern 99 forms an inductance element L5. The obverse surface of the coil-shaped electrode pattern 99 is provided with a protective film made of resin. As a result, the inductance elements L1 and L2 defined by the coil-shaped electrode patterns, which are board-side electrode patterns, are magnetically coupled with the coil-shaped electrode pattern 99.

The operation and effect of the fifteenth example are basically the same as those of the first example. That is, in the electromagnetic-coupling module 10, a high-frequency signal (for example, a UHF frequency band) emitted from a reader/writer (not shown) is received at the radiation plate 20, and the feeder circuit 16 (the LC series resonance circuit formed of an inductance element L2 and a capacitance element C2) that is capacitively and magnetically coupled with the radiation plate 20 is caused to resonate. Thereby, only a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted to the radiation plate 20 via capacitive coupling and magnetic coupling, and is transmitted and transferred from the radiation plate 20 to the reader/writer. The feeder circuit 16 and the wireless IC chip 5 are magnetically coupled by the inductance elements L1 and L5, and power and a transmission/receiving signal are transmitted.

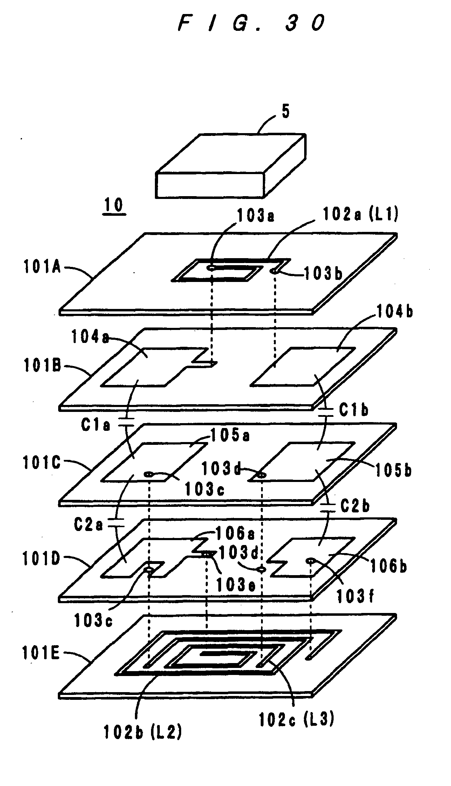

### (Sixteenth Example of Electromagnetic-Coupling Module, See Figs. 29 and 30)

As shown as an equivalent circuit in Fig. 29, in an electromagnetic-coupling module 1p of a sixteenth example, a feeder circuit 16 includes inductance elements L1, L2, and L3 that are magnetically coupled with one another at a high degree of coupling. The inductance element L1 is magnetically coupled with an inductance element L5 provided in a wireless IC chip 5. The inductance element L2 and capacitance elements C1a and C1b form an LC series resonance circuit, and the inductance element L3 and capacitance elements C2a and C2b form an LC series resonance circuit. The inductance elements L1, L2, and L3 are each magnetically coupled with a radiation plate 20.

More specifically, as shown in Fig. 30, a feeder circuit board 10 is obtained by laminating, press-bonding and sintering ceramic sheets 101A to 101E made of a dielectric. The feeder circuit board 10 includes a sheet 101A on which a conductor pattern 102a and viahole conductors 103a and 103b are formed; a sheet 101B on which capacitor electrodes 104a and 104b are formed; a sheet 101C on which capacitor electrodes 105a and 105b and viahole conductors 103c and 103d are formed; a sheet 101D on which capacitor electrodes 106a and 106b and viahole conductors 103c, 103d, 103e, and 103f are formed; and a sheet 101E on which conductor patterns 102b and 102c are formed. That is, spaces are provided among the electrodes 104a, 105a and 106a defining the capacitance elements C1a and C2a and among the electrodes 104b, 105b and 106b defining the capacitance elements C1b and C2b so that a magnetic flux generated by the inductance element L1 reaches the inductance elements L2 and L3 and further reaches the radiation plate 20.

By stacking these sheets 101A to 101E, the conductor pattern 102a forms the inductance element L1. The conductor pattern 102b forms the inductance element L2. The conductor pattern 102c forms the inductance element L3. The capacitor electrodes 104a and 105a form the capacitance element C1a. The capacitor electrodes 104b and 105b form the capacitance element C1b. Furthermore, the capacitor electrodes 105a and 106a form the capacitance element C2a. The capacitor electrodes 105b and 106b form the capacitance element C2b.

One end of the inductance element L1 is connected to the capacitor electrode 104a via the viahole conductor 103a, and the other end thereof is connected to the capacitor electrode 104b via the viahole conductor 103b. One end of the inductance element L2 is connected to the capacitor electrode 105a via the viahole conductor 103c, and the other end thereof is connected to the capacitor electrode 106b via the viahole conductor 103f. One end of the inductance element L3 is connected to the capacitor electrode 106a via the viahole conductor 103e, and the other end thereof is connected to the capacitor electrode 105b via the viahole conductor 103d.

As shown in Fig. 28, on the reverse surface of the wireless IC chip 5, a coil-shaped electrode pattern 99 is provided as a chip-side electrode pattern, and the coil-shaped electrode pattern 99 forms the inductance element L5. On the obverse surface of the coil-shaped electrode pattern 99, a protective film made of resin is provided. As a result, the inductance element L1 defined by the coil-shaped electrode pattern, that is a board-side electrode pattern, and the coil-shaped electrode pattern 99 are magnetically coupled with each other.

The operation and effect of the sixteenth example are basically the same as those of the fourteenth example. That is, in the electromagnetic-coupling module 1p, a high-frequency signal (for example, a UHF frequency band) emitted from a reader/writer (not shown) is received at the radiation plate 20, and the feeder circuit 16 (the LC series resonance circuit formed of an inductance element L2 and capacitance elements C1a and C1b, and the LC series resonance circuit formed of an inductance element L3 and capacitance elements C2a and C2b) that is magnetically coupled with the radiation plate 20 is caused to resonate. Thereby, only a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted to the radiation plate 20 from the inductance elements L1, L2, and L3 of the feeder circuit 16 via magnetic coupling, and is transmitted and transferred from the radiation plate 20 to the reader/writer. The feeder circuit 16 and the wireless IC chip 5 are magnetically coupled with the inductance elements L1 and L5, and power and a transmission/receiving signal are transmitted.

In particular, in the sixteenth example, since the feeder circuit 16 is configured by a plurality of LC resonance circuits including the inductance elements L2 and L3 that are magnetically coupled with each other, the frequency band is wide as in the case of the fourteenth example.

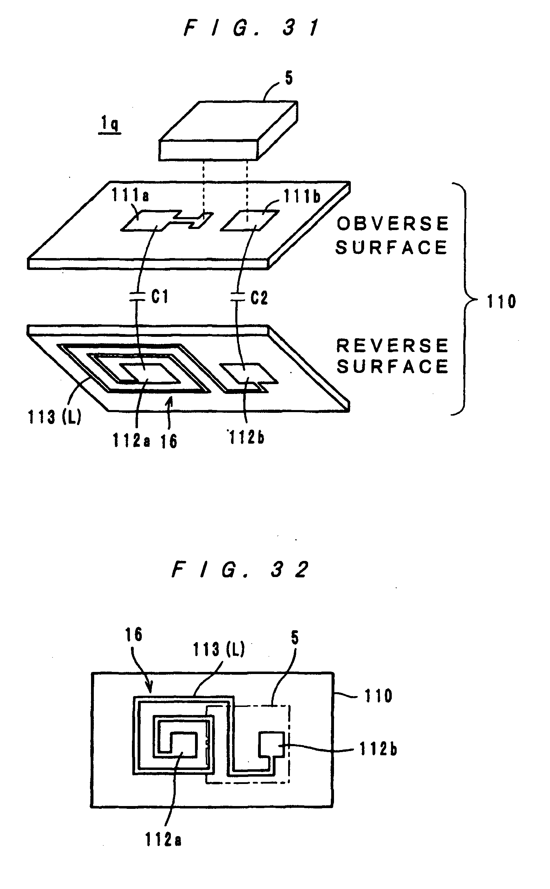

### (Seventeenth Example of Electromagnetic-Coupling Module, See Figs. 31 to 34, not conforming to the invention)

In an electromagnetic-coupling module 1q of a seventeenth example, a feeder circuit board 110 is configured by a single-layer board, and the equivalent circuit thereof is the same as that of Fig. 3. That is, the feeder circuit 16 is defined as an LC series resonance circuit in which capacitance elements C1 and C2 are connected to both ends of an inductance element L. The feeder circuit board 110 is a ceramic board made of a dielectric. As shown in Fig. 31, on the obverse surface thereof, capacitor electrodes 111a and 111b are formed, and on the reverse surface thereof, capacitor electrodes 112a and 112b and a conductor pattern 113 are formed. The capacitor electrodes 111a and 112a form a capacitance element C1, and the capacitor electrodes 111b and 112b form a capacitance element C2.

The operation and effect of the seventeenth example are basically the same as those of the first example. That is, in the electromagnetic-coupling module 1q, a high-frequency signal (for example, a UHF frequency band) emitted from a reader/writer (not shown) is received at the radiation plate 20, and the feeder circuit 16 (the LC series resonance circuit formed of an inductance element L and capacitance elements C1 and C2) that is magnetically coupled with the radiation plate 20 is caused to resonate. Thereby, only a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted to the radiation plate 20 from the inductance element L of the feeder circuit 16 via magnetic coupling, and is transmitted and transferred from the radiation plate 20 to the reader/writer.

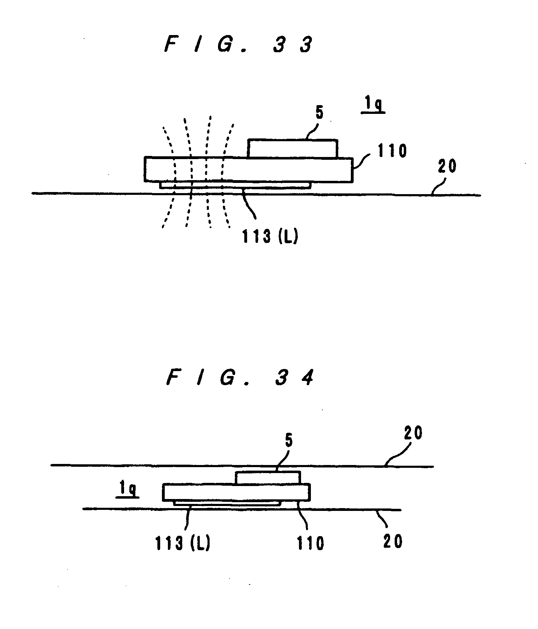

In particular, in the seventeenth example, as shown in Figs. 32 and 33, the inductance element L is disposed so as to overlap the wireless IC chip 5 only partially in plan view. As a result, most of the magnetic flux generated in the inductance element L is not shielded by the wireless IC chip 5, and the rise of the magnetic flux becomes satisfactory.

In the seventeenth example, as shown in Fig. 34, the feeder circuit board 110 with the wireless IC chip 5 mounted thereon may be sandwiched between the radiation plates 20 and 20. The magnetic coupling efficiency of the feeder circuit 16 and the radiation plates 20 and 20 is improved, and the gain is improved.

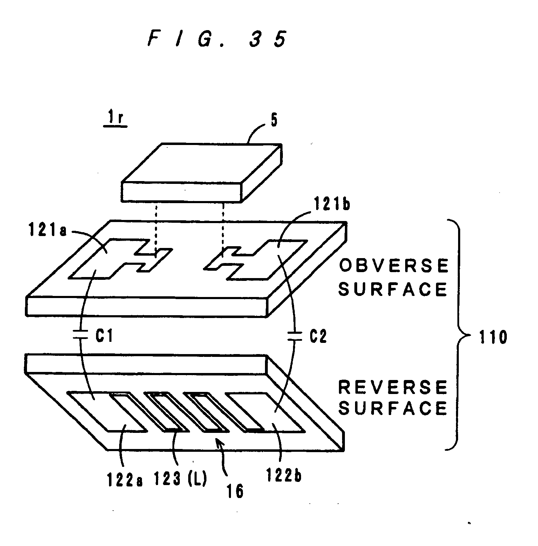

### (Eighteenth Example of Electromagnetic-Coupling Module, See Fig. 35, not conforming to the invention)

In an electromagnetic-coupling module 1r of an eighteenth example, an inductance element L is formed by a meandering line electrode pattern, and the equivalent circuit thereof is the same as that of Fig. 3. That is, a feeder circuit 16 is defined as an LC series resonance circuit in which capacitance elements C1 and C2 are connected to both ends of an inductance element L. The feeder circuit board 110 is a ceramic single-layer board made of a dielectric. As shown in Fig. 35, on the obverse surface thereof, capacitor electrodes 121a and 121b are formed, and on the reverse surface thereof, capacitor electrodes 122a and 122b and a meandering conductor pattern 123 are formed. The capacitor electrodes 121a and 122a form a capacitance element C1, and the capacitor electrodes 121b and 122b form a capacitance element C2.

The operation and effect of the eighteenth example are basically the same as those of the first example. That is, in the electromagnetic-coupling module 1r, a high-frequency signal (for example, a UHF frequency band) emitted from a reader/writer (not shown) is received at a radiation plate opposing the conductor pattern 123, and the feeder circuit 16 (the LC series resonance circuit formed of an inductance element L and capacitance elements C1 and C2) that is magnetically coupled with the radiation plate is caused to resonate. Thereby, only a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted to the radiation plate from the inductance element L of the feeder circuit 16 via magnetic coupling, and is transmitted and transferred from the radiation plate 20 to the reader/writer.

In particular, in the eighteenth example, since the inductance element L is defined by the meandering conductor pattern 123, and it is effective for transmitting and receiving high-frequency signals.

In the seventeenth example and in the eighteenth example, it is also possible to construct the feeder circuit board 110 by using a multilayer board.

Next, embodiments of various articles to which the above-described electromagnetic-coupling modules are attached will be described.

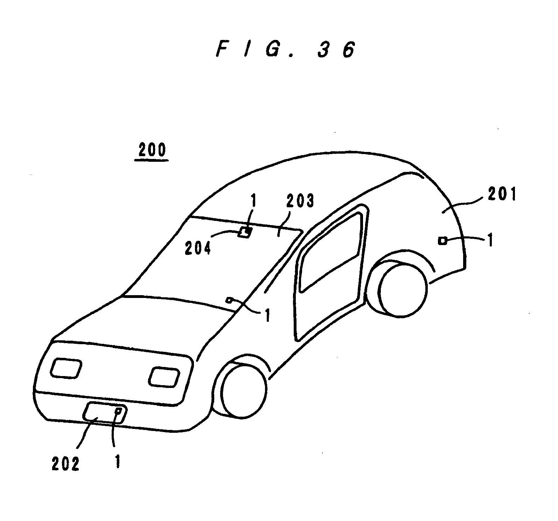

### (First Embodiment, See Fig. 36)

As shown in Fig. 36, in a first embodiment, the present invention is applied to an automobile 200, and a car body 201, including a steel plate part, of the automobile 200 is used as a radiation plate. The electromagnetic-coupling module 1 is bonded to the steel plate part of the car body 201, and the feeder circuit is electromagnetically coupled with the steel plate part (radiation plate). Asset management of the automobile 200 can be performed on the basis of automobile inspection information, automobile registration information, user information, and the like stored in a wireless IC chip provided in the electromagnetic-coupling module 1. The electromagnetic-coupling module 1 may be bonded (contained) to a number-plate 202 so that the number-plate 202 functions as a radiation plate. Alternatively, a metal object, such as a defogger (a defogging conductor pattern) may be used as a radiation plate.

When the electromagnetic-coupling module 1 is bonded to the number-plate 202, information, such as the registration number, the registration date, and the automobile inspection information of the automobile 200, is stored in the wireless IC chip, and the information is transmitted to a roadside unit having a reader. In this case, the number-plate 202 functions as an electronic number-plate (smart plate). The electromagnetic-coupling module 1 employs a passive system, that is, a system in which a battery is not contained and an electrical current is generated by using an electromagnetic wave input from outside as a driving source. Accordingly, problems, such as a battery run-down, do not occur. Also, by mounting an RFID reader on an investigating vehicle, it is possible to easily find a car having a forged number-plate, a stolen car, or the like even in an area in which a roadside unit is not disposed.

The first embodiment is not limited to be applied to the automobile 200 and may be applied to other vehicles, such as an airplane, a ship, a bus, construction equipment (e.g. a crane or a forklift), a motorcycle and a bicycle, and asset management thereof can be performed.

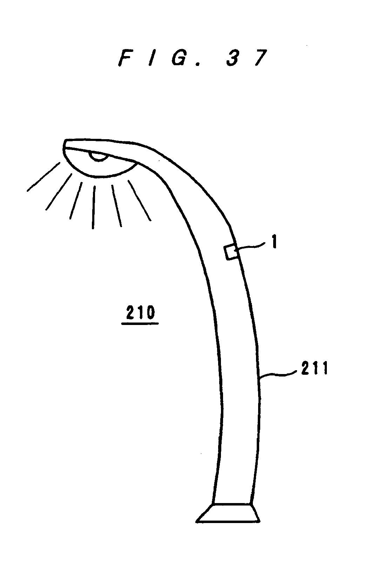

### (Second Embodiment, See Fig. 37)

As shown in Fig. 37, a second embodiment is applied to a lamp 210 disposed in an expressway. The electromagnetic-coupling module 1 is bonded to a metal pole part 211 of the lamp 210, and the pole part 211 is used as a radiation plate. The feeder circuit of the electromagnetic-coupling module 1 is electromagnetically coupled with the pole part 211. Asset management can be performed on the basis of the installation date, equipment information, and used materials of the lamp 210, and the like, which are stored in the wireless IC chip. In addition to the lamp 210, it is also possible to perform asset management of equipment installed in a public park, a public building, and the like.

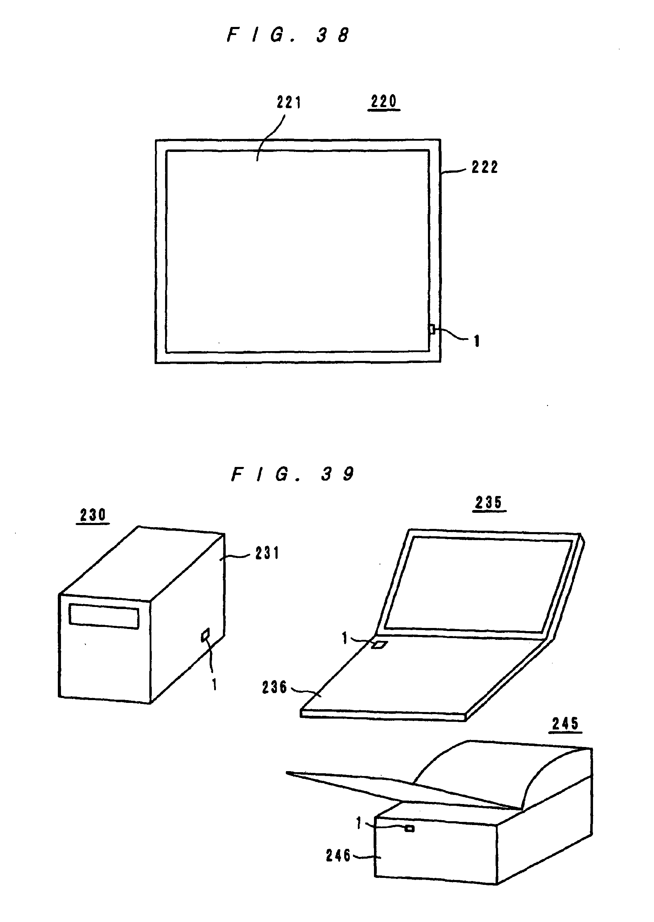

### (Third Embodiment, See Fig. 38)

As shown in Fig. 38, in a third embodiment, the invention is applied to electronic paper 220 formed of a display screen 221 and a frame part 222, and the metal frame part 222 of the electronic paper 220 is used as a radiation plate. The feeder circuit of the electromagnetic-coupling module 1 is electromagnetically coupled with the frame part 222. It is possible to perform asset management on the basis of the purchase date, the purchase price, the purchaser, and the like of the electronic paper 220, which are stored in the wireless IC chip.

### (Fourth Embodiment, See Fig. 39)

In a fourth embodiment, as shown in Fig. 39, metal housing part 231 of a body 230 of a desk-top computer or a housing part 236 of a notebook computer 235 is used as a radiation plate. The feeder circuit of the electromagnetic-coupling module 1 is electromagnetically coupled with the housing part 231 or 236. A housing part 246 of a printer 245 may be used as a radiation plate. It is possible to perform asset management based on the purchase date, the purchase price, and the like of the body 230, the notebook computer 235 or the printer 245 stored in the wireless IC chip.

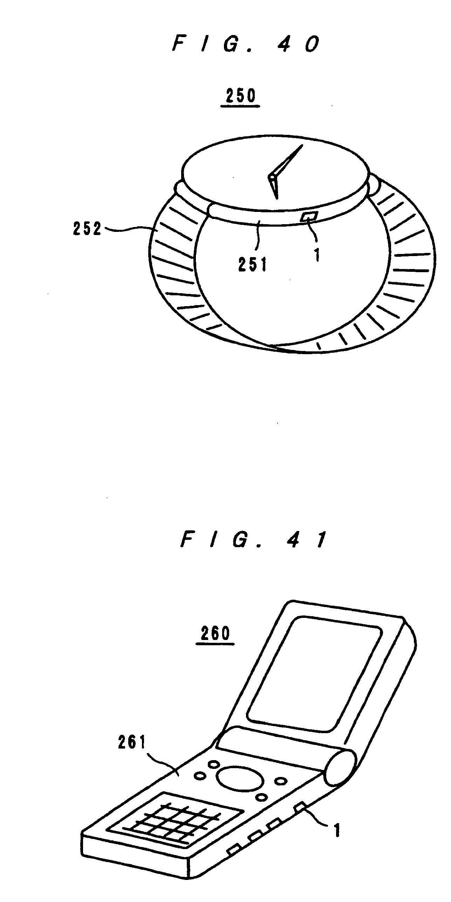

### (Fifth Embodiment, See Fig. 40)

In a fifth embodiment, as shown in Fig. 40, a metal case 251 or a metal strap 252 of a wristwatch 250 is used as a radiation plate. The feeder circuit of the electromagnetic-coupling module 1 is electromagnetically coupled with the case 251 or the strap 252. It is possible to perform asset management on the basis of the purchase date, the purchase price, and the like of the wristwatch 250 stored in the wireless IC chip.

### (Sixth Embodiment, See Fig. 41)

In a sixth embodiment, as shown in Fig. 41, a metal housing part 261 (a conductive paint applied onto the housing if the housing part is non-metal) of a mobile phone 260 is used as a radiation plate. The feeder circuit of the electromagnetic-coupling module 1 is electromagnetically coupled with the housing part 261 or the conductive paint. It is possible to perform asset management of the purchase date, the purchase price, and the like of the mobile phone 260. Such asset management can be applied not only to the mobile phone 260 but also to other mobile devices, such as a PDA, a digital camera, a portable game machine, and a communication device.

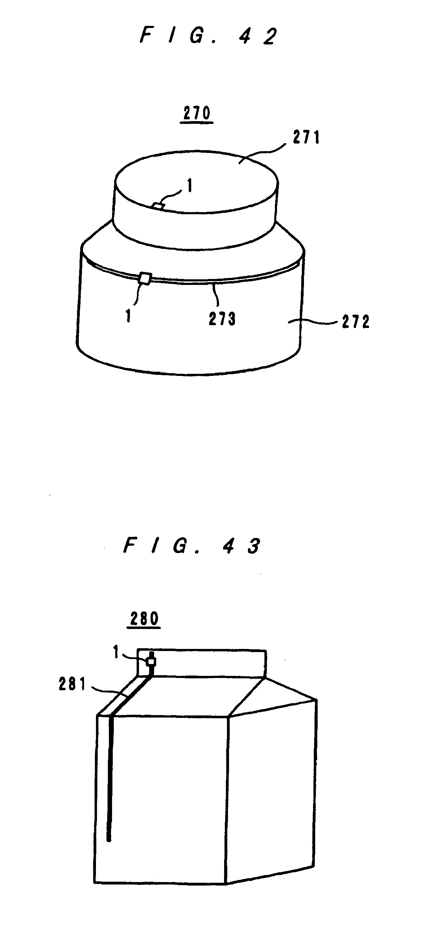

### (Seventh Embodiment, See Fig. 42)

In a seventh embodiment, as shown in Fig. 42, an aluminum lid 271 of a jar 270 for preserving food is used as a radiation plate. The feeder circuit of the electromagnetic-coupling module 1 is electromagnetically coupled with the lid 271, and the electromagnetic-coupling module 1 communicates with a reader/writer of an RFID system. In the seventh embodiment, it is possible to perform asset management of the manufacturing date, the kind of food, and the like. Furthermore, by storing distribution history of the food in the wireless IC chip and by timely updating the history, inventory control becomes easy.

If the lid 271 is made of resin and cannot be used as a radiation plate, a radiation plate 273 is printed on a label 272 of the jar 270 using a conductive paint as a part of the design of the label 272, and the electromagnetic-coupling module 1 is bonded thereto.

### (Eighth Embodiment, See Fig. 43)

In an eighth embodiment, as shown in Fig. 43, a radiation plate 281 is printed on a carton 280 of milk or juice using a conductive paint as a part of the design, and the electromagnetic-coupling module 1 is bonded thereto. The usage of the eighth embodiment is the same as that of the seventh embodiment. A can of canned meat or other food may be used as a radiation plate, and a conductive paint printed on a wrapping of potato chips may be used as a radiation plate. That is, the eighth embodiment can be used for wrapped food in general.

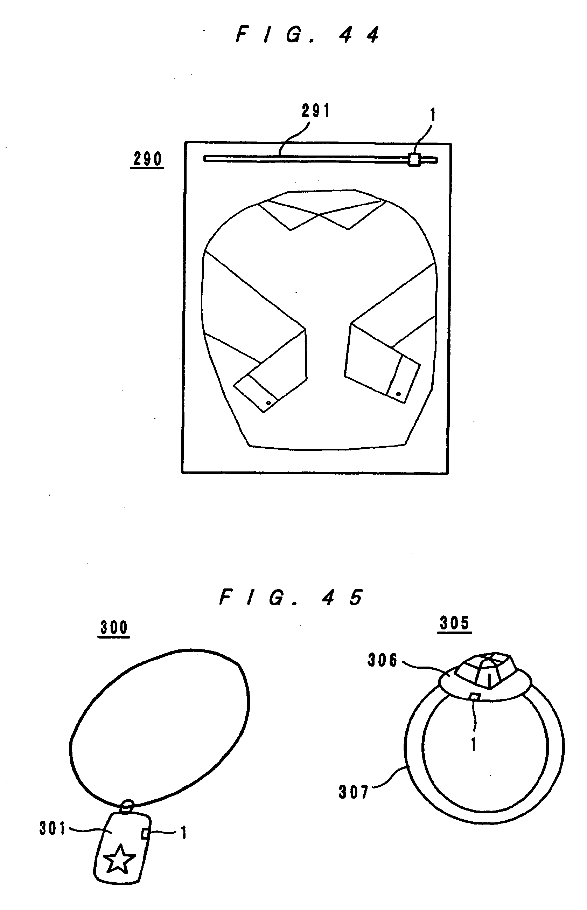

### (Ninth Embodiment, See Fig. 44)

In a ninth embodiment, as shown in Fig. 44, a radiation plate 291 is printed on a wrapping bag 290 for clothes using a conductive paint as a part of the design of the wrapping bag 290, and the electromagnetic-coupling module 1 is bonded thereto. The usage of the ninth embodiment is the same as that of the seventh embodiment. The article contained in the wrapping bag 290 is not limited to clothes and may be stationeries, daily goods, and the like.

### (Tenth Embodiment, See Fig. 45)

In a tenth embodiment, as shown in Fig. 45, a metal charm 301 of a pendant 300, and a metal setting 306 or a metal band 307 of a ring 305 are used as a radiation plate. The feeder circuit of the electromagnetic-coupling module 1 is electromagnetically coupled with the charm 301 or the setting 306, and the electromagnetic-coupling module 1 communicates with a reader/writer of an RFID system. Also, in the tenth embodiment, it is possible to perform asset management of the purchase date, the purchase price, and the like. Furthermore, by storing distribution history and the like in the wireless IC chip and timely updating the history, inventory control becomes easy.

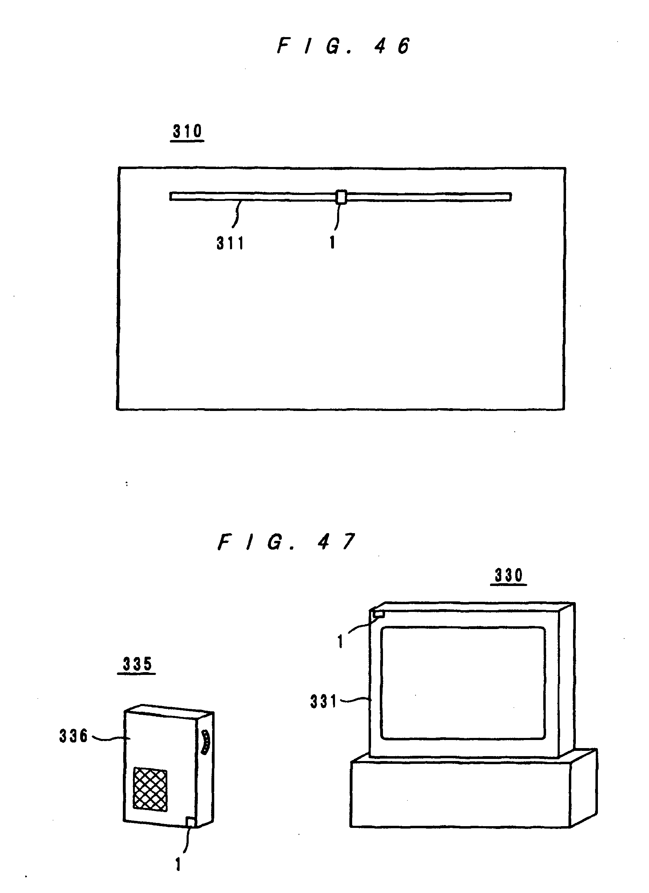

### (Eleventh Embodiment, See Fig. 46)

In an eleventh embodiment, as shown in Fig. 46, a radiation plate 311 is printed on a security 310 using a conductive paint as a part of the design of the security 310, and the electromagnetic-coupling module 1 is bonded thereto. The eleventh embodiment can be used for asset management on the basis of value information stored in the wireless IC chip as an RFID system and can be used for the determination of authenticity of the security 310.

The eleventh embodiment can be applied not only to the security 310 but also to other paper products, such as paper money, an important document, an invoice, an envelope, a receipt form, a freight label, or a book. A document may be formed as a double-sheet laminate structure, and the radiation plate 311 and the electromagnetic-coupling module 1 may be inserted in the laminate structure. Alternatively, the radiation plate 311 and the electromagnetic-coupling module 1 may be provided inside an envelope, a book, or the like.

### (Twelfth Embodiment, See Fig. 47)

In a twelfth embodiment, as shown in Fig. 47, a metal housing part 331 or 336 (a conductive paint may be applied onto the housing if the housing part is non-metal) of a television 330 or a radio 335 is used as a radiation plate. The feeder circuit of the electromagnetic-coupling module 1 is electromagnetically coupled with the housing part 331 or 336 or the conductive paint. It is possible to perform asset management by using an RFID system of the television 330 and the radio 335. The twelfth embodiment can also be applied to other AV home appliances as well as a television and a radio.

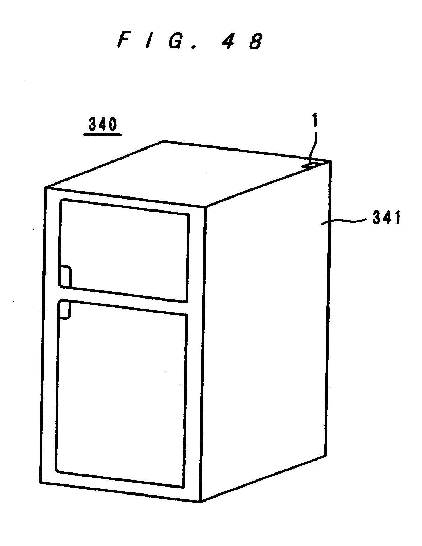

### (Thirteenth Embodiment, See Fig. 48)

In a thirteenth embodiment, as shown in Fig. 48, a metal housing part 341 of a refrigerator 340 is used as a radiation plate. The feeder circuit of the electromagnetic-coupling module 1 is electromagnetically coupled with the housing part 341, and asset management of the refrigerator 340 is possible. The thirteenth embodiment can also be applied to large household appliances as well as the refrigerator 340.

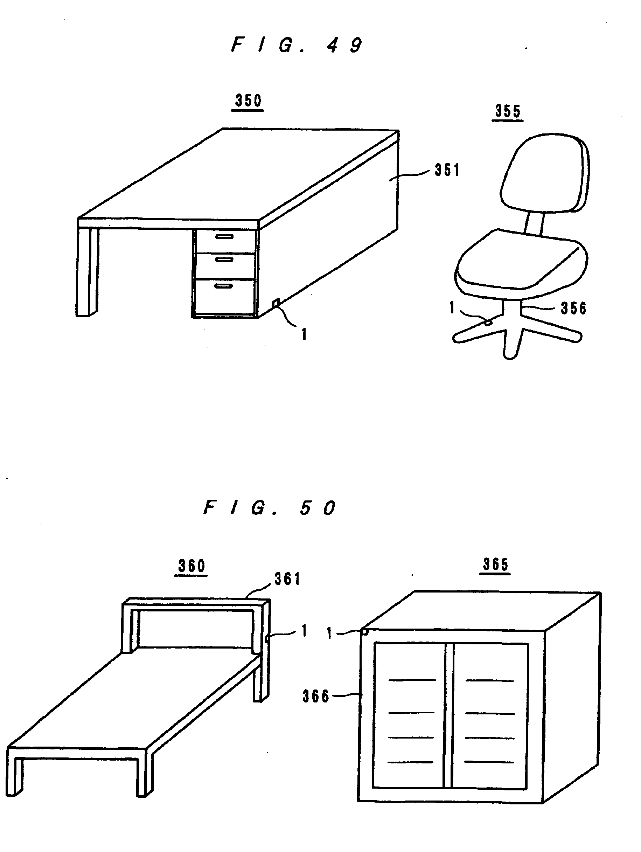

### (Fourteenth Embodiment, See Fig. 49)

In a fourteenth embodiment, as shown in Fig. 49, a metal housing part 351 of a desk 350 or a metal leg part 356 of a chair 355 is used as a radiation plate. The feeder circuit of the electromagnetic-coupling module 1 is electromagnetically coupled with the housing part 351 or the leg part 356, and the electromagnetic-coupling module 1 communicates with a reader/writer of an RFID system. In the fourteenth embodiment, the electromagnetic-coupling module 1 is mainly used for management of fixed asset, such as for prevention of robbery. Of course, if distribution history and the like are stored in the wireless IC chip and are timely updated, the electromagnetic- coupling module 1 can also be used for inventory control at the distribution stage. The fourteenth embodiment can be widely applied to various kinds of office furniture in addition to the desk 350 and the chair 355.

### (Fifteenth Embodiment, See Fig. 50)

In a fifteenth embodiment, as shown in Fig. 50, a metal frame 361 of a bed 360 or a housing part 366 of a cabinet 365 are used as a radiation plate. The feeder circuit of the electromagnetic-coupling module 1 is electromagnetically coupled with the frame 361 or the housing part 366, and the electromagnetic-coupling module 1 communicates with a reader/writer of an RFID system. The usage of the fifteenth embodiment is the same as that of the fourteenth embodiment. The fifteenth embodiment can be widely applied to various kinds of household furniture, fixtures of a hotel, and the like as well as the bed 360 and the cabinet 365.

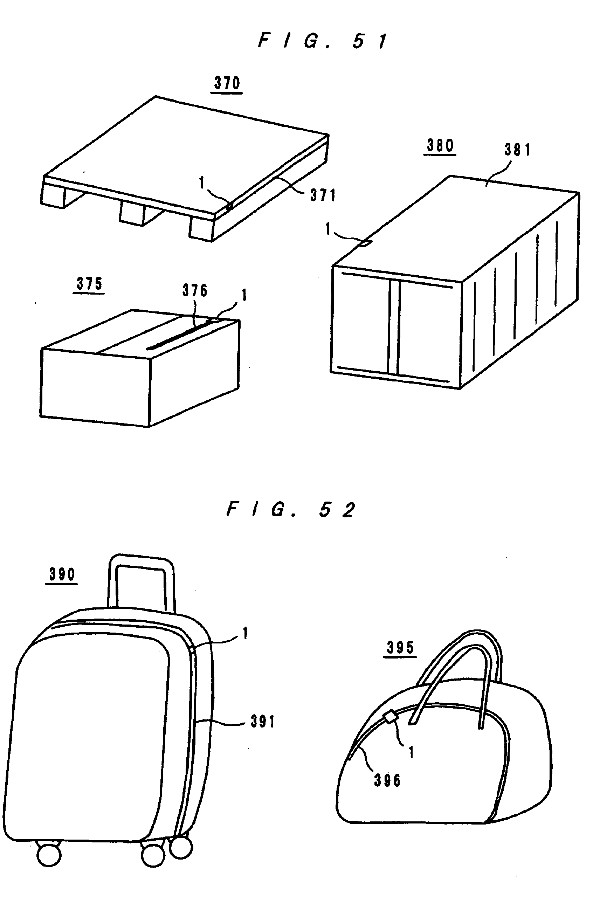

### (Sixteenth Embodiment, See Fig. 51)

In a sixteenth embodiment, as shown in Fig. 51, a metal plate part 371 (a conductive paint may be applied to the plate part if the plate part is non-metal) of a palette 370, a conductive paint 376 applied to a cardboard box 375 or a metal housing part 381 of a freight container 380 is used as a radiation plate. The feeder circuit of the electromagnetic-coupling module 1 is electromagnetically coupled with the metal plate part 371, the conductive paint 376 or the housing part 381, and the electromagnetic-coupling module 1 communicates with a reader/writer of an RFID system. The electromagnetic-coupling module 1 is used for management of fixed asset and distribution management of articles.

### (Seventeenth Embodiment, See Fig. 52)

In a seventeenth embodiment, as shown in Fig. 52, the electromagnetic-coupling module 1 is bonded to a metal fastener part 391 of a suitcase 390 or to a radiation plate 396 printed on a surface of a bag 395 by using a conductive paint as a part of the design. The feeder circuit of the electromagnetic-coupling module 1 is electromagnetically coupled with the fastener part 391 or the radiation plate 396, and the electromagnetic-coupling module 1 communicates with a reader/writer of an RFID system. The seventeenth embodiment can be applied not only to asset management of the suitcase 390 and the bag 395 but also to distribution management in an airport or the like.

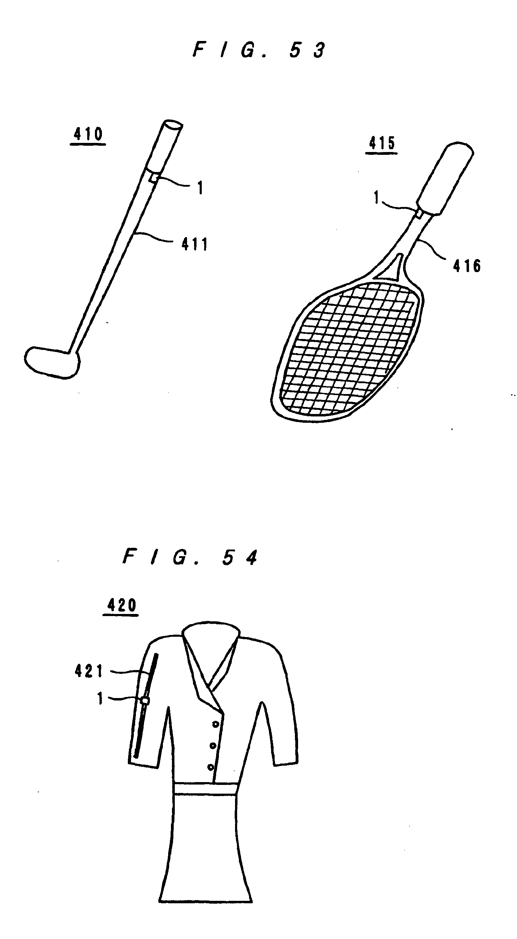

### (Eighteenth Embodiment, See Fig. 53)

In an eighteenth embodiment, as shown in Fig. 53, a carbon shaft 411 of a golf club 410 or a carbon shaft 416 of a tennis racket 415 is used as a radiation plate. The feeder circuit of the electromagnetic-coupling module 1 is electromagnetically coupled with the shaft 411 or 416, and the electromagnetic-coupling module 1 communicates with a reader/writer of an RFID system. The eighteenth embodiment is used for the above-described management of fixed asset and distribution management of articles, and can also be widely applied to other sports goods.

### (Nineteenth Embodiment, See Fig. 54)

In a nineteenth embodiment, as shown in Fig. 54, the electromagnetic-coupling module 1 is bonded to a radiation plate 421 provided on clothes 420 by using a conductive paint as a part of the design. The feeder circuit of the electromagnetic-coupling module 1 is electromagnetically coupled with the radiation plate 421, and the electromagnetic-coupling module 1 communicates with a reader/writer of an RFID system. The manufacture number, the manufacture date, the price, and the like of the clothes 420 are stored in the wireless IC chip, and the nineteenth embodiment is used for management of fixed asset and distribution management of articles.

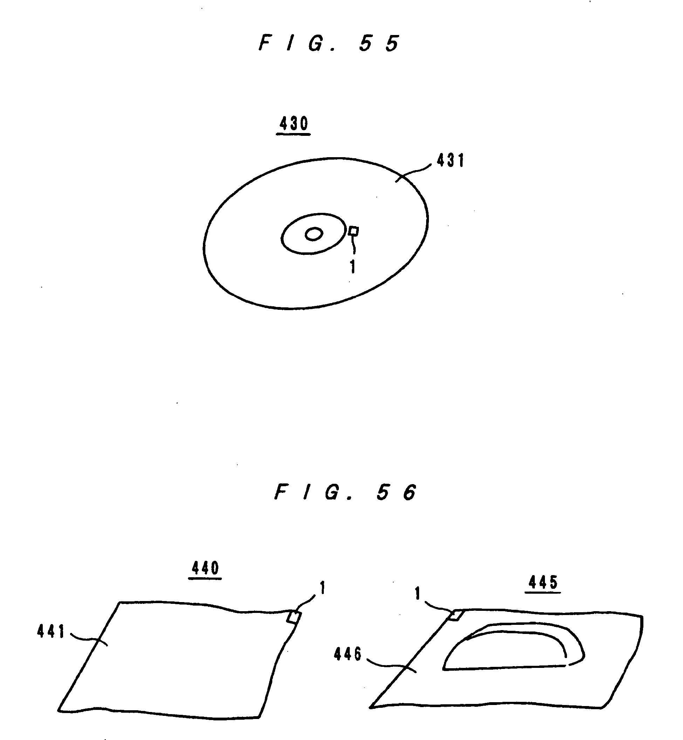

### (Twentieth Embodiment, See Fig. 55)

In a twentieth embodiment, as shown in Fig. 55, an aluminum film 431 deposited on a recording medium 430, such as a DVD or a CD, is used as a radiation plate. The feeder circuit of the electromagnetic-coupling module 1 is electromagnetically coupled with the aluminum film 431, and the electromagnetic-coupling module 1 communicates with a reader/writer of an RFID system.

The twentieth embodiment is used for asset management and distribution management. In the twentieth embodiment, also, by using a player which inhibits a replay without receiving information from a wireless IC chip attached to the medium, the electromagnetic-coupling module 1 can also be used for prevention of illegal copying.

### (Twenty-First Embodiment, See Fig. 56)

In a twenty-first embodiment, as shown in Fig. 56, an aluminum film 441 or 446 of a package 440 or 445 of a medical product is used as a radiation plate. The package 440 is for a granule of medicine, and the package 445 is for a tablet of medicine. The feeder circuit of the electromagnetic-coupling module 1 is electromagnetically coupled with the aluminum film 441 or 446, and the electromagnetic-coupling module 1 communicates with a reader/writer of an RFID system. In the twenty-first embodiment, the manufacture date, the components, the method for administering the medicine, the directions for taking the medicine, and the like of a medical product are stored in the wireless IC chip. Thereby, the twenty-first embodiment is used for asset management and distribution management of medical products, and also, it is possible to discriminate authorized medicine and unauthorized medicine from each other in a package-by-package manner.

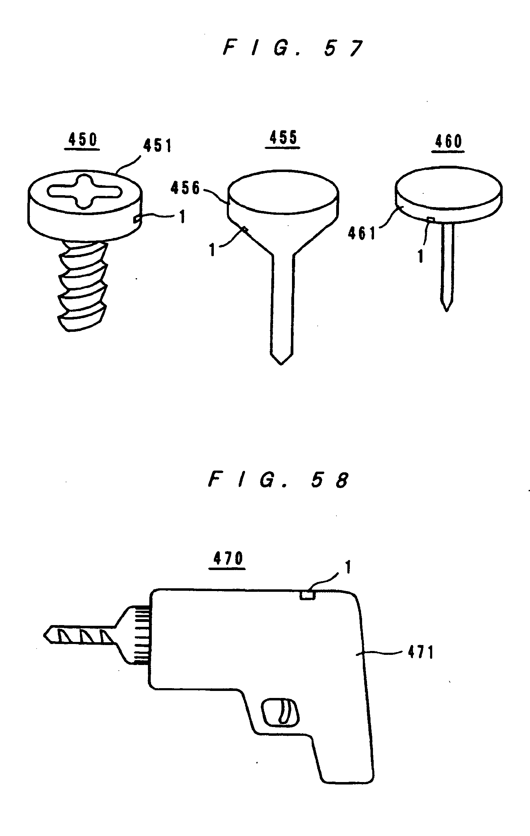

### (Twenty-Second Embodiment, See Fig. 57)

In a twenty-second embodiment, as shown in Fig. 57, a metal screw 450, a metal nail 455, or a metal pin 460 itself is used as a radiation plate. The electromagnetic-coupling module 1 is mounted to a head part 451, 456 or 461 of the screw 450, the nail 455 of the pin 460. The feeder circuit of the electromagnetic-coupling module 1 is electromagnetically coupled with the screw 450, the nail 455, or the pin 460, and the electromagnetic-coupling module 1 communicates with a reader/writer of an RFID system. In the twenty-second embodiment, the electromagnetic-coupling module 1 can be used for asset management of the screw 450 and the like. If the screw 450 is a screw for precise construction, such as for assembly of an airplane, a fastening torque, a construction period, a construction method, and the like may be stored in the wireless IC chip so as to be managed.

### (Twenty-Third Embodiment, See Fig. 58)

In a twenty-third embodiment, as shown in Fig. 58, a metal body 471 of a power tool 470 is used as a radiation plate. The feeder circuit of the electromagnetic-coupling module 1 is electromagnetically coupled with the body 471, and the electromagnetic-coupling module 1 communicates with a reader/writer of an RFID system. In the twenty-third embodiment, the electromagnetic-coupling module 1 can be used for asset management and distribution management of the power tool 470 and other tools. Also, the electromagnetic-coupling module 1 can be used for management of each tool inside a tool box.

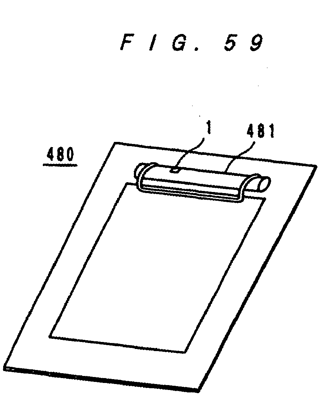

### (Twenty-Fourth Embodiment, See Fig. 59)

In a twenty-fourth embodiment, as shown in Fig. 59, metal fittings 481 of a clipboard 480 is used as a radiation plate. The feeder circuit of the electromagnetic-coupling module 1 is electromagnetically coupled with the metal fittings 481, and the electromagnetic-coupling module 1 communicates with a reader/writer of an RFID system. In the twenty-fourth embodiment, the electromagnetic-coupling modules 1 are used for asset management and distribution management of the clipboard 480 and other stationeries. Also, by communication between each of the electromagnetic-coupling modules 1 bonded to the clipboard 480 and other stationeries and the electromagnetic-coupling module 1 provided for a cabinet, storage management and storage position management inside a cabinet is possible.

### (Other Embodiments)

An article with an electromagnetic-coupling module according to the present invention is not limited to the above-described embodiments, and can be variously changed within the scope and spirit of the present invention.

In particular, the electromagnetic-coupling module can be mounted to various kinds of articles as well as the articles described in connection with the embodiments above. Furthermore, details of the internal configuration of the feeder circuit board and the shape of the radiation plate can be arbitrarily designed. In order to connect a wireless IC chip to a feeder circuit board, processing other than soldering may be used.

### Industrial Applicability

As has been described, the present invention is useful for an article with an electromagnetic-coupling module having a wireless IC chip used in an RFID system, and is excellent in that an article with an electromagnetic-coupling module having a wireless IC chip and having stable frequency characteristics can be obtained.

## Claims

1. An article with an electromagnetic-coupling module, comprising an article (200-480), and an electromagnetic-coupling module (1 a-1 r) attached to the article (200-480),
wherein the electromagnetic-coupling module (1a-1r) comprises a wireless IC chip (5); and
wherein the article (200-480) comprises a radiation plate (20);
**characterized in that**
the electromagnetic-coupling module (1a-1r) comprises a feeder circuit board (10) on which the wireless IC chip (5) is mounted and in which a feeder circuit (16) including a resonance circuit having a predetermined resonance frequency is provided; and
the radiation plate (20) is configured to radiate a transmission signal supplied from the feeder circuit (16) of the electromagnetic-coupling module via electromagnetic coupling and/or for supplying a received reception signal to the feeder circuit (16) via electromagnetic coupling; and
the radiation plate (20) is a metal object that is originally possessed by the article.

2. The article with an electromagnetic-coupling module according to Claim 1, wherein the resonance circuit is a lumped-constant resonance circuit formed of a capacitor element (C1, C2) and an inductor element (L).

3. The article with an electromagnetic-coupling module according to Claim 2, wherein the lumped-constant resonance circuit is an LC series resonance circuit or an LC parallel resonance circuit.

4. The article with an electromagnetic-coupling module according to Claim 3, wherein the lumped-constant resonance circuit is configured to include a plurality of LC series resonance circuits or a plurality of LC parallel resonance circuits.

5. The article with an electromagnetic-coupling module according to one of Claims 2 to 4, wherein the capacitor element (C1, C2) is disposed downstream of the wireless IC chip (5) and between the wireless IC chip (5) and the inductor element (L).

6. The article with an electromagnetic-coupling module according to one of Claims 2 to 5, wherein the feeder circuit board (10) is a multilayer board (11A-G; 31A-F; 41A-F; 51A-D; 71A-F; 81A-H; 91A-E; 101A-E) including a plurality of dielectric layers or magnetic layers, and the capacitor element (C1, C2) and the inductor element (L) are formed inside the multilayer board.

7. The article with an electromagnetic-coupling module according to one of Claims 1 to 6, wherein the feeder circuit board (10) is a rigid board made of resin or ceramic.

8. The article with an electromagnetic-coupling module according to one of Claims 1 to 7, wherein an electrical length of the radiation plate (20) is an integral multiple of a half wavelength of the resonance frequency.

9. The article with an electromagnetic-coupling module according to one of Claims 1 to 8, wherein the wireless IC chip (5) is provided with a chip-side electrode pattern, the feeder circuit board (10) is provided with a first board-side electrode pattern (32; 42; 52; 75a, 75b), and the wireless IC chip (5) and the feeder circuit board (10) are directly connected electrically to each other by the chip-side electrode pattern and the first board-side electrode pattern (32; 42; 52; 75a, 75b).

10. The article with an electromagnetic-coupling module according to one of Claims 1 to 9, wherein the wireless IC chip (5) is provided with a chip-side electrode pattern (87a, 87b), the feeder circuit board (10) is provided with a first board-side electrode pattern (86a, 86b), and the wireless IC chip (5) and the feeder circuit board (10) are connected to each other by capacitive coupling between the chip-side electrode pattern (87a, 87b) and the first board-side electrode pattern (86a, 86b).

11. The article with an electromagnetic-coupling module according to Claim 10, wherein the chip-side electrode pattern (87a, 87b) and the first board-side electrode pattern (86a, 86b) are mutually parallel planar electrode patterns, and the wireless IC chip (5) and the feeder circuit board (10) are bonded together via a dielectric adhesive layer.

12. The article with an electromagnetic-coupling module according to one of Claims 1 to 8, wherein the wireless IC chip (5) is provided with a chip-side electrode pattern (99), the feeder circuit board (10) is provided with a first board-side electrode pattem (92a, 92b; 102a), and the wireless IC chip (5) and the feeder circuit board (10) are connected to each other by magnetic coupling between the chip-side electrode pattern (99) and the first board-side electrode pattern (92a, 92b; 102a).

13. The article with an electromagnetic-coupling module according to Claim 12, wherein each of the chip-side electrode pattern (99) and the first board-side electrode pattern (92a, 92b; 102a) is a coil-shaped electrode pattern, and the wireless IC chip (5) and the feeder circuit board (10) are bonded together via an insulating or magnetic adhesive layer.

14. The article with an electromagnetic-coupling module according to one of Claims 1 to 13, wherein the feeder circuit board (10) is provided with a second board-side electrode pattern (72a, 72b), and the feeder circuit board (10) and the radiation plate (20) are connected to each other by capacitive coupling between the second board-side electrode pattern (72a, 72b) and the radiation plate (20).

15. The article with an electromagnetic-coupling module according to Claim 14, wherein the second board-side electrode pattern (72a, 72b) is a planar electrode pattern disposed in parallel to the radiation plate (20), and the feeder circuit board (10) and the radiation plate (20) are bonded together via a dielectric adhesive layer.

16. The article with an electromagnetic-coupling module according to one of Claims 1 to 13, wherein the feeder circuit board (10) is provided with a second board-side electrode pattern (82a, 82b), and the feeder circuit board (10) and the radiation plate (20) are bonded together by magnetic coupling between the second board-side electrode pattern (82a, 82b) and the radiation plate (20).

17. The article with an electromagnetic-coupling module according to Claim 16, wherein the second board-side electrode pattern (82a, 82b) is a coil-shaped electrode pattern, and the feeder circuit board (10) and the radiation plate (20) are bonded together via an insulating or magnetic adhesive layer.

## Patentansprüche

1. Ein Artikel mit einem Elektromagnetische-Kopplung-Modul, der einen Artikel (200-480) und ein an dem Artikel (200-480) befestigtes Elektromagnetische-Kopplung-Modul (1 a-1 r) umfasst,
wobei das Elektromagnetische-Kopplung-Modul (1a-1r) einen Drahtlose-IC-Chip (5) umfasst; und
wobei der Artikel (200-480) eine Strahlungsplatte (20) umfasst;
**dadurch gekennzeichnet, dass**
das Elektromagnetische-Kopplung-Modul (1a-1r) eine Speiseschaltungsplatine (10) aufweist, auf der der Drahtlose-IC-Chip (5) angebracht ist und in der eine Speiseschaltung (16), die eine Resonanzschaltung mit einer vorbestimmten Resonanzfrequenz umfasst, vorgesehen ist; und
die Strahlungsplatte (20) dazu konfiguriert ist, ein von der Speiseschaltung (16) des Elektromagnetische-Kopplung-Moduls über eine elektromagnetische Kopplung bereitgestelltes Übertragungssignal auszustrahlen und/oder ein empfangenes Empfangssignal über eine elektromagnetische Kopplung an die Speiseschaltung (16) zu liefern; und
die Strahlungsplatte (20) ein Metallobjekt ist, das der Artikel ursprünglich besitzt.

2. Der Artikel mit einem Elektromagnetische-Kopplung-Modul gemäß Anspruch 1, bei dem die Resonanzschaltung eine aus einem Kondensatorelement (C1, C2) und einem Induktorelement (L) gebildete Resonanzschaltung mit konzentrierten Elementen ist.

3. Der Artikel mit einem Elektromagnetische-Kopplung-Modul gemäß Anspruch 2, bei dem die Resonanzschaltung mit konzentrierten Elementen eine LC-Reihenresonanzschaltung oder eine LC-Parallelresonanzschaltung ist.

4. Der Artikel mit einem Elektromagnetische-Kopplung-Modul gemäß Anspruch 3, bei dem die Resonanzschaltung mit konzentrierten Elementen dazu konfiguriert ist, eine Mehrzahl von LC-Reihenresonanzschaltungen oder eine Mehrzahl von LC-Parallelresonanzschaltungen zu umfassen.

5. Der Artikel mit einem Elektromagnetische-Kopplung-Modul gemäß einem der Ansprüche 2 bis 4, bei dem das Kondensatorelement (C1, C2) in Flussrichtung nach dem Drahtlose-IC-Chip (5) und zwischen dem Drahtlose-IC-Chip (5) und dem Induktorelement (L) angeordnet ist.

6. Der Artikel mit einem Elektromagnetische-Kopplung-Modul gemäß einem der Ansprüche 2 bis 5, bei dem die Speiseschaltungsplatine (5) eine Mehrlagenschaltungsplatine (11A-G; 31A-F; 41A-F; 51A-D; 71A-F; 81A-H; 91A-E; 101A-E) ist, die eine Mehrzahl von dielektrischen Schichten oder magnetischen Schichten umfasst, und das Kondensatorelement (C1, C2) und das Induktorelement (L) in der Mehrlagenplatine gebildet sind.

7. Der Artikel mit einem Elektromagnetische-Kopplung-Modul gemäß einem der Ansprüche 1 bis 6, bei dem die Speiseschaltungsplatine (10) eine aus Harz oder Keramik hergestellte starre Platine ist.

8. Der Artikel mit einem Elektromagnetische-Kopplung-Modul gemäß einem der Ansprüche 1 bis 7, bei dem eine elektrische Länge der Strahlungsplatte (20) ein ganzzahliges Vielfaches einer halben Wellenlänge der Resonanzfrequenz ist.

9. Der Artikel mit einem Elektromagnetische-Kopplung-Modul gemäß einem der Ansprüche 1 bis 8, bei dem der Drahtlose-IC-Chip (5) mit einer chipseitigen Elektrodenstruktur versehen ist, die Speiseschaltungsplatine (10) mit einer ersten platinenseitigen Elektrodenstruktur (32; 42; 52; 75a, 75b) versehen ist und der Drahtlose-IC-Chip (5) und die Speiseschaltungsplatine (10) durch die chipseitige Elektrodenstruktur und die erste platinenseitige Elektrodenstruktur (32; 42; 52; 75a, 75b) direkt elektrisch miteinander verbunden sind.

10. Der Artikel mit einem Elektromagnetische-Kopplung-Modul gemäß einem der Ansprüche 1 bis 9, bei dem der Drahtlose-IC-Chip (5) mit einer chipseitigen Elektrodenstruktur (87a, 87b) versehen ist, die Speiseschaltungsplatine (10) mit einer ersten platinenseitigen Elektrodenstruktur (86a, 86b) versehen ist und der DrahtloseIC-Chip (5) und die Speiseschaltungsplatine (10) anhand einer kapazitiven Kopplung zwischen der chipseitigen Elektrodenstruktur (87a, 87b) und der ersten platinenseitigen Elektrodenstruktur (86a, 86b) miteinander verbunden sind.

11. Der Artikel mit einem Elektromagnetische-Kopplung-Modul gemäß Anspruch 10, bei dem die chipseitige Elektrodenstruktur (87a, 87b) und die erste platinenseitige Elektrodenstruktur (86a, 86b) zueinander parallele planare Elektrodenstrukturen sind und der Drahtlose-IC-Chip (5) und die Speiseschaltungsplatine (10) über eine dielektrische Haftschicht miteinander verbunden sind.

12. Der Artikel mit einem Elektromagnetische-Kopplung-Modul gemäß einem der Ansprüche 1 bis 8, bei dem der Drahtlose-IC-Chip (5) mit einer chipseitigen Elektrodenstruktur (99) versehen ist, die Speiseschaltungsplatine (10) mit einer ersten platinenseitigen Elektrodenstruktur (92a, 92b; 102a) versehen ist und der Drahtlose-IC-Chip (5) und die Speiseschaltungsplatine (10) durch eine magnetische Kopplung zwischen der chipseitigen Elektrodenstruktur (99) und der ersten platinenseitigen Elektrodenstruktur (92a, 92b; 102a) miteinander verbunden sind.

13. Der Artikel mit einem Elektromagnetische-Kopplung-Modul gemäß Anspruch 12, bei dem sowohl die chipseitige Elektrodenstruktur (99) als auch die erste platinenseitige Elektrodenstruktur (92a, 92b; 102a) eine spulenförmige Elektrodenstruktur ist und der Drahtlose-IC-Chip (5) und die Speiseschaltungsplatine (10) über eine isolierende oder magnetische Haftschicht miteinander verbunden sind.

14. Der Artikel mit einem Elektromagnetische-Kopplung-Modul gemäß einem der Ansprüche 1 bis 13, bei dem die Speiseschaltungsplatine (10) mit einer zweiten platinenseitigen Elektrodenstruktur (72a, 72b) versehen ist und die Speiseschaltungsplatine (10) und die Strahlungsplatte (20) durch eine kapazitive Kopplung zwischen der zweiten platinenseitigen Elektrodenstruktur (72a, 72b) und der Strahlungsplatte (20) miteinander verbunden sind.

15. Der Artikel mit einem Elektromagnetische-Kopplung-Modul gemäß Anspruch 14, bei dem die zweite platinenseitige Elektrodenstruktur (72a, 72b) eine parallel zu der Strahlungsplatte (20) angeordnete planare Elektrodenstruktur ist und die Speiseschaltungsplatine (10) und die Strahlungsplatte (20) über eine dielektrische Haftschicht miteinander verbunden sind.

16. Der Artikel mit einem Elektromagnetische-Kopplung-Modul gemäß einem der Ansprüche 1 bis 13, bei dem die Speiseschaltungsplatine (10) mit einer zweiten platinenseitigen Elektrodenstruktur (82a, 82b) versehen ist und die Speiseschaltungsplatine (10) und die Strahlungsplatte (20) durch eine magnetische Kopplung zwischen der zweiten platinenseitigen Elektrodenstruktur (82a, 82b) und der Strahlungsplatte (20) miteinander verbunden sind.

17. Der Artikel mit einem Elektromagnetische-Kopplung-Modul gemäß Anspruch 16, bei dem die zweite platinenseitige Elektrodenstruktur (82a, 82b) eine spulenförmige Elektrodenstruktur ist und die Speiseschaltungsplatine (10) und die Strahlungsplatte (20) über eine isolierende oder magnetische Haftschicht miteinander verbunden sind.

## Revendications

1. Article pourvu d'un module de couplage électromagnétique, comprenant un article (200-480) et un module de couplage électromagnétique (1a-1r) fixé à l'article (200-480),
dans lequel le module de couplage électromagnétique (1a-1r) comprend une puce électronique sans fil (5) ; et
dans lequel l'article (200-480) comprend une plaque de rayonnement (20) ;
**caractérisé en ce que**
le module de couplage électromagnétique (1a-1r) comprend une carte de circuit imprimé d'alimentation (10) sur laquelle la puce électronique sans fil (5) est montée et dans lequel un circuit d'alimentation (16) comprenant un circuit à résonance ayant une fréquence de résonance prédéterminée est prévu ; et
la plaque de rayonnement (20) est configurée de façon à rayonner un signal de transmission délivré en sortie par le circuit d'alimentation (16) du module de couplage électromagnétique via un couplage électromagnétique et/ou de façon à transmettre un signal de réception reçu au circuit d'alimentation (16) via un couplage électromagnétique; et
la plaque de rayonnement (20) est un objet métallique qui fait initialement partie de l'article.

2. Article pourvu d'un module de couplage électromagnétique selon la revendication 1, dans lequel le circuit à résonance est un circuit à résonance à constantes localisées comprenant un élément condensateur (C1, C2) et un élément inducteur (L).

3. Article pourvu d'un module de couplage électromagnétique selon la revendication 2, dans lequel le circuit à résonance à constantes localisées est un circuit à résonance à LC série ou un circuit à résonance à LC parallèle.

4. Article pourvu d'un module de couplage électromagnétique selon la revendication 3, dans lequel le circuit à résonance à constantes localisées est configuré de façon à comprendre une pluralité de circuits à résonance à LC série ou une pluralité de circuits à résonance à LC parallèles.

5. Article pourvu d'un module de couplage électromagnétique selon l'une des revendications 2 à 4, dans lequel l'élément condensateur (C1, C2) est disposé en aval de la puce électronique sans fil (5) et entre la puce électronique sans fil (5) et l'élément inducteur (L).

6. Article pourvu d'un module de couplage électromagnétique selon l'une des revendications 2 à 5, dans lequel la carte de circuit imprimé d'alimentation (10) est une carte multicouche (11A-G ; 31A-F ; 41A-F ; 51A-D ; 71A-F ; 81A-H ; 91A-E ; 101A-E) comprenant une pluralité de couches diélectriques ou de couches magnétiques, et l'élément condensateur (C1, C2) et l'élément inducteur (L) sont formés à l'intérieur de la carte multicouche.

7. Article pourvu d'un module de couplage électromagnétique selon l'une des revendications 1 à 6, dans lequel la carte de circuit imprimé d'alimentation (10) est une carte rigide faite en résine ou en céramique.

8. Article pourvu d'un module de couplage électromagnétique selon l'une des revendications 1 à 7, dans lequel une longueur électrique de la plaque de rayonnement (20) est un entier multiple d'une demi-longueur d'onde de la fréquence de résonance.

9. Article pourvu d'un module de couplage électromagnétique selon l'une des revendications 1 à 8, dans lequel la puce électronique sans fil (5) comprend un motif d'électrode sur le côté puce, la carte de circuit imprimé d'alimentation (10) comprend un premier motif d'électrode sur le côté carte (32 ; 42 ; 52 ; 75a, 75b), et la puce électronique sans fil (5) et la carte de circuit imprimé d'alimentation (10) sont directement connectées électriquement l'une à l'autre par le motif d'électrode sur le côté puce et le premier motif d'électrode sur le côté carte (32 ; 42 ; 52 ; 75a, 75b).

10. Article pourvu d'un module de couplage électromagnétique selon l'une des revendications 1 à 9, dans lequel la puce électronique sans fil (5) comprend un motif d'électrode sur le côté puce (87a, 87b), la carte de circuit imprimé d'alimentation (10) comprend un premier motif d'électrode sur le côté carte (86a, 86b), et la puce électronique sans fil (5) et la carte de circuit imprimé d'alimentation (10) sont connectées l'une à l'autre via un couplage capacitif entre le motif d'électrode sur le côté puce (87a, 87b) et le premier motif d'électrode sur le côté carte (86a, 86b).

11. Article pourvu d'un module de couplage électromagnétique selon la revendication 10, dans lequel le motif d'électrode sur le côté puce (87a, 87b) et le premier motif d'électrode sur le côté carte (86a, 86b) sont des motifs d'électrode planaires mutuellement parallèles, et la puce électronique sans fil (5) et la carte de circuit imprimé d'alimentation (10) sont liées ensemble via une couche adhésive diélectrique.

12. Article pourvu d'un module de couplage électromagnétique selon l'une des revendications 1 à 8, dans lequel la puce électronique sans fil (5) comprend un motif d'électrode sur le côté puce (99), la carte de circuit imprimé d'alimentation (10) comprend un premier motif d'électrode sur le côté carte (92a, 92b ; 102a) et la puce électronique sans fil (5) et la carte de circuit imprimé d'alimentation (10) sont connectées l'une à l'autre via un couplage magnétique entre le motif d'électrode sur le côté puce (99) et le premier motif d'électrode sur le côté carte (92a, 92b ; 102a).

13. Article pourvu d'un module de couplage électromagnétique selon la revendication 12, dans lequel chacun du motif d'électrode sur le côté puce (99) et du premier motif d'électrode sur le côté carte (92a, 92b ; 102a) est un motif d'électrode en forme de bobine, et la puce électronique sans fil (5) et la carte de circuit imprimé d'alimentation (10) sont liées ensemble via une couche adhésive isolante ou magnétique.

14. Article pourvu d'un module de couplage électromagnétique selon l'une des revendications 1 à 13, dans lequel la carte de circuit imprimé d'alimentation (10) comprend un second motif d'électrode sur le côté carte (72a, 72b), et la carte de circuit imprimé d'alimentation (10) et la plaque de rayonnement (20) sont connectées l'une à l'autre via un couplage capacitif entre le second motif d'électrode sur le côté carte (72a, 72b) et la plaque de rayonnement (20).

15. Article pourvu d'un module de couplage électromagnétique selon la revendication 14, dans lequel le second motif d'électrode sur le côté carte (72a, 72b) est un motif d'électrode planaire disposé en parallèle par rapport à la plaque de rayonnement (20), et la carte de circuit imprimé d'alimentation (10) et la plaque de rayonnement (20) sont liées ensemble via une couche adhésive diélectrique.

16. Article pourvu d'un module de couplage électromagnétique selon l'une des revendications 1 à 13, dans lequel la carte de circuit imprimé d'alimentation (10) comprend un second motif d'électrode sur le côté carte (82a, 82b), et la carte de circuit imprimé d'alimentation (10) et la plaque de rayonnement (20) sont liées ensemble via un couplage magnétique entre le second motif d'électrode sur le côté carte (82a, 82b) et la plaque de rayonnement (20).

17. Article pourvu d'un module de couplage électromagnétique selon la revendication 16, dans lequel le second motif d'électrode sur le côté carte (82a, 82b) est un motif d'électrode en forme de bobine, et la carte de circuit imprimé d'alimentation (10) et la plaque de rayonnement (20) sont liées ensemble via une couche adhésive isolante ou magnétique.
